(19) Europäisches Patentamt / European Patent Office / Office européen des brevets

(11) **EP 2 715 375 B1**

(12) **EUROPEAN PATENT SPECIFICATION**

(45) Date of publication and mention
of the grant of the patent:
**22.08.2018 Bulletin 2018/34**

(21) Application number: **12729026.0**

(22) Date of filing: **29.05.2012**

(51) Int Cl.:
**G01R 15/24** *(2006.01)*

(86) International application number:
**PCT/EP2012/060065**

(87) International publication number:
**WO 2012/163924 (06.12.2012 Gazette 2012/49)**

(54) **FIBER-OPTIC VOLTAGE SENSOR**

FASEROPTISCHER SPANNUNGSSENSOR

CAPTEUR DE TENSION À FIBRE OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.05.2011 EP 11167811**

(43) Date of publication of application:
**09.04.2014 Bulletin 2014/15**

(73) Proprietor: **ABB Research Ltd.**
**8050 Zürich (CH)**

(72) Inventors:
• **STEIGER, Olivier**
  **CH-8032 Zürich (CH)**
• **JORIS, Pascal**
  **CH-4142 Münchenstein (CH)**
• **BOHNERT, Klaus**
  **CH-5452 Oberrohrdorf (CH)**
• **MARCHESE, Sergio Vincenzo**
  **CH-8050 Zürich (CH)**
• **WILDERMUTH, Stephan**
  **69514 Laudenbach (DE)**

(74) Representative: **ABB Patent Attorneys**
**c/o ABB Schweiz AG**
**Intellectual Property CH-IP**
**Brown Boveri Strasse 6**
**5400 Baden (CH)**

(56) References cited:
EP-A1- 1 179 735    DE-A1- 19 716 477
US-A- 4 904 931     US-A- 5 113 131
US-A- 5 715 058     US-B1- 6 252 388

• J. PASCAL, S. ADAM, O. STEIGER, W.R. WERBANETS: "Optimization of an Electro-Optic Voltage Transducer using a VHDL-AMS model", PROCEDIA ENGINEERING, EUROSENSORS XXV, vol. 25, 7 September 2011 (2011-09-07), pages 59-62, XP002684622,
• SHIWU XIAO ET AL: "Novel Optic High Voltage Transducer Based on Gaussian Quadrature Method", POWER AND ENERGY ENGINEERING CONFERENCE (APPEEC), 2010 ASIA-PACIFIC, IEEE, PISCATAWAY, NJ, USA, 28 March 2010 (2010-03-28), pages 1-5, XP031658381, ISBN: 978-1-4244-4812-8
• PATRICK P CHAVEZ ET AL: "Accurate Voltage Measurement by theQuadrature Method", IEEE TRANSACTIONS ON POWER DELIVERY, IEEE SERVICE CENTER, NEW YORK, NY, US, vol. 18, no. 1, 1 January 2003 (2003-01-01), XP011078907, ISSN: 0885-8977

**Description**

Technical Field

The present invention relates to a method and device for measuring a voltage, in particular an AC voltage in the high-voltage range.

Introduction and Background Art

Optical high-voltage sensors often rely on electro-optic effects (such as Pockels effect and/or Kerr effect) in crystalline materials such as $Bi_4Ge_3O_{12}$ (BGO) (L. Duvillaret, S. Rialland, and J.-L. Coutaz "Electro-optic sensors for electric field measurements. II. Choice of the crystal and complete optimization of their orientation" J. Opt. Soc. Am. B 19 2704 (2002)).

US 4,904,931 and US 5,001,419 disclose a sensor in which the full line voltage (up to several 100 kV) is applied over the length of a single BGO crystal (typically between 100 mm and 250 mm length). The crystal class of BGO is of symmetry such that the crystal measures the line integral ∫E*ds over the crystal length, i.e. from ground to high-voltage potential. As a result, stray fields, e.g., from neighboring phases do not influence the measurement. The applied voltage introduces a differential optical phase shift between two orthogonal linearly polarized light waves propagating along parallel optical paths through the same crystal. This phase shift is proportional to the applied voltage. The light waves interfere at a polarizer at the end of the crystal. The resulting light intensity varies in proportion to a DC biased cosine function of the phase shift. At typical voltages in high-voltage substations, the phase shift may correspond to several multiples of $\pi$ and thus results in ambiguous sensor output. The ambiguity is resolved by adding a second optical output path to the crystal containing a quarter-wave retarder that introduces a 90°-phase offset between the interfering waves. A signal processor reconstructs the waveform of the applied voltage from the two optical output signals at quadrature. Herein, a bidirectional cumulative count of zero crossings of the two electric signals is incremented or decremented depending upon which of the two electrical signals is leading. From the cumulative count of zero crossings a staircase approximation of the waveform is generated. Improved accuracy of the output signal is achieved by interpolating the stairstep waveform via adding or subtracting selectively the magnitude of the smaller of the two opto-electrical signals, with the sense of the adjustment being determined by the relative polarities of the two electrical signals. As the electric field strength at the crystal is typically very high, the crystal is mounted in a hollow high-voltage insulator made of fiber-reinforced epoxy and filled with $SF_6$ gas under pressure in order to obtain sufficient dielectric strength. The insulator diameter is large enough to keep the field strength in the air outside the insulator below critical limits.

US 6,252,388 describes a voltage sensor which uses several smaller electro-optic crystals mounted at selected positions along the longitudinal axis of a hollow high-voltage insulator. The crystals measure the electric fields at their locations. The sum of these local field measurements serves as an approximation of the voltage applied to the insulator. In this case the electro-optic phase shift at each crystal is within $\pm 90°$ at the rated voltage, i.e. there is no ambiguity in the sensor response.

US 5,247,244 discloses an electro-optic voltage measuring system in reflection and with temperature compensation. Again, the high voltage is applied along a single crystal and two optically parallel light beams are traversed through the full crystal length and are phase-shifted relative to one another. Temperature compensation is effected via measurement of capacitive current through the electro-optic crystal, and a correction factor is derived and applied to the half-wave voltage and is used to calculate the instantaneous voltage value.

US 5,715,058 discloses another electro-optic sensor for measuring high voltages in a reflective setup. High voltage is applied to the crystal and the crystal is traversed forth and back by a single light beam. This light beam is split only after exiting from the crystal into two optical paths that are phase-shifted relative to one another. Temperature compensation is achieved by measuring a temperature-dependence of the phase shifting waveplate.

Other art is known from EP1179735.

Disclosure of the Invention

It is a general objective of the invention to accurately measure voltages over a large range in a simple manner.

This objective is achieved by the method and the device of the independent claims. Exemplary embodiments are disclosed in the dependent claims and claim combinations.

The invention relates to a method for measuring a voltage, in particular a full voltage and/or a partial voltage between a first terminal and second terminal, the first terminal being spatially separated from the second terminal and the voltage creating an electric field between the terminals, the method comprising the steps of

arranging at least a first electro-optical light transmitting element in the electric field between the first and the second terminal,

passing light through the first electro-optical light transmitting element,
measuring at least a first signal, e.g. $S_n$, from the first electro-optical light transmitting element and further measuring a second signal, e.g. $S_n'$, from the first or a second electro-optical light transmitting element, wherein both signals are periodic functions of the voltage and have a relative phase shift other than zero, i.e. a relative phase shift with respect to each other, and possibly a relative phase shift with the applied voltage V or $V_n$,
deriving the voltage and resolving an ambiguity in the deriving of the voltage (V) from the first and the second signal, characterized by the steps of:

(i) using the first signal as a base signal indicative of the electric field over the first electro-optical light transmitting element,
(ii) using the second signal as a reference signal for resolving the ambiguity in the deriving of the voltage,
(iii) determining from the first signal **at least** two hypotheses, e.g. $h^+$ and $h^-$, corresponding to different possible voltage values, e.g. $V_1^{h+}$ and $V_1^{h-}$, of the voltage, e.g. $V_n$ for n=1,
(iv) deriving an expected value, e.g. $S_2^{h+}$ and $S_2^{h-}$, of the second signal for each of the hypotheses,
(v) comparing the expected values to a measured value of the second signal, and
(vi) taking a binary decision between the hypotheses by validating that hypthesis for which the expected value is closest to the measured value of the second signal.

In an embodiment, exactly two hypotheses are determined and exactly one reference signal per base signal is used, and/or closeness of the expected values to the measured value is determined using Euclidean distance.

In an embodiment, the base signal is a cosinusoidal of the voltage V or $V_n$, and the voltage under the first hypthesis is assumed to be proportial to +arccos, and the voltage under the second hypthesis is assumed to be proportial to -arccos.

In an embodiment, the relative phase shift is different from 90°.

In an embodiment, the base signal is normalized to a symmetric value range around zero, in particular the base signal is scaled and offset to a value range [+1, -1].

In another embodiment, the deriving of the voltage comprises reconstructing an improved waveform of the voltage with the steps of: determining first voltage values of the voltage from the base signal, in particular by calculating an arccosine, determining second voltage values of the voltage from the reference signal, in particular by calculating an arccosine, and determining the improved voltage waveform from the first voltage values and the second voltage values, in particular wherein the base signal and the reference signal are derived from the same light transmitting element.

A further embodiment comprises the steps of: for each n-th electro-optical light transmitting element, in particular for exactly one electro-optical light transmitting element, normalizing the base signal and the reference signal to the same maximum and minimum amplitude, in particular to unity, selecting a weighting parameter $\beta_n$ with $0=<\beta_n=<1$, and determining the improved voltage waveform by calculating a weighted sum $V=\sum V_n = \sum\{\beta_n*V_{1n} + (1-\beta_n)*v_{2n}\}$, with $V_{1n}$, $V_{2n}$= first and second voltage values of the n-th electro-optical light transmitting element. For example in the case of exactly one electro-optical light transmitting element, the full voltage V is determined by calculating the weighted sum $V = \beta*V_{11} + (1-\beta)*V_{21}$, with $V_{11}$, $V_{21}$= first and second voltage values of the exactly one first electro-optical light transmitting element.

A further embodiment comprises the steps of: selecting the weighting parameter $\beta_n$ such that the more linear of the base signal and the reference signal as a function of the voltage is given a bigger weight.

A further embodiment comprises the steps of: selecting the weighting parameter $\beta_n$=1 when an absolute value of the base signal is smaller than an absolute value of the reference signal, and selecting the weighting parameter $\beta_n$=0 when an absolute value of the reference signal is smaller than an absolute value of the base signal.

A further embodiment comprises the steps of: selecting the weighting parameter $\beta_n$ as a continuous function of the voltage, in particular according to $\beta_n = \cos^2(S_n*\pi/2)/(\cos^2(S_n*\pi/2)+\sin^2(S_n'*\pi/2)$.

In another embodiment, the second electro-optical light transmitting element is used, and the second signal is measured from the second electro-optical light transmitting element, and the hypotheses correspond to different possible voltage values of the partial voltage applied to the first electro-optical light transmitting element.

Another embodiment comprises the steps of: using at least two electro-optical light transmitting elements and subjecting them to individual partial voltages, measuring the first signal for each n-th electro-optical light transmitting element and using it as the n-th base signal indicative of the electric field over that n-th electro-optical light transmitting element, determining the second signal for each n-th electro-optical light transmitting element and using it as the n-th reference signal for resolving the ambiguity in the deriving of the n-th partial voltage over that n-th electro-optical light transmitting element, and for each n-th electro-optical light transmitting element performing the method steps (iii), (iv), (v) and (vi) to disambiguate the partial voltage over that n-th electro-optical light transmitting element, and determining the full voltage between the first and second terminal from the partial voltages.

In an embodiment, the electro-optical light transmitting elements are optically read out in parallel.

In another embodiment, exactly one electro-optical light transmitting element is used, and the hypotheses correspond to different possible voltage values of the full voltage between the first terminal and the second terminal.

Yet another embodiment comprises performing for each n-th electro-optic light transmitting element and its corresponding base signal and/or reference signal ($S_n'$) the steps of: reconstructing a waveform of the measured voltage, in particular the full voltage and/or partial voltage between the first terminal and the second terminal, calculating a time average over a number of periods of the reconstructed waveform, determining from the time average an apparent DC offset voltage $V_{DC}$, and calculating a relative phase $\Delta_n$ of the base signal and/or reference signal ($S_n'$), in particular a relative phase shift with respect to the applied voltage $V_n$, according to $\Delta_n = V_{DC}*\pi/V_{h,n}$, with $V_{h,n}$ = half-wave voltage of the nth electro-optic light transmitting element.

Another aspect of the invention, in particular a further embodiment, comprises the steps of: (i) using the first signal as a base signal indicative of the electric field over the first electro-optical light transmitting element,

(ii) using the second signal as a reference signal for resolving the ambiguity in the deriving of the voltage, (iii) determining from the first signal two hypotheses corresponding to different possible voltage values of the voltage, (iv) determining the actual relative phase shift between the base signal and the reference signal, (v) determining from the base signal, the reference signal and the actual relative phase shift a synthetic quadrature signal having an ideal relative phase shift of 90°, and (vi) taking a binary decision between the hypotheses based on the sign of the synthetic quadrature signal.

In an embodiment, the step (vi) of taking the binary decision comprises: selecting the more positive of the possible voltage values $V_1^{h-}$ and $V_1^{h+}$, if the sign is negative and $\Delta=+90°$, and selecting the more negative of the possible voltage values $V_1^{h-}$ and $V_1^{h+}$, if the sign is positive and $\Delta=+90°$; and vice versa if $\Delta=-90°$.

In an embodiment, the step (v) comprises: calculating the synthetic quadrature signal ($S_n'^{quad}$) according to the formula $S_n'^{quad} = \cos^{-1}(2*\pi*\Delta) * S_n' + \tan(2*\pi*\Delta) * S_n$.

In an embodiment, at least two electro-optical light transmitting elements (sensor modules, e.g., comprising electro-optical crystals, poled waveguides, or piezo-electric devices), are arranged in the electric field between two spaced-apart terminals with the to-be-measured voltage applied to the terminals. Light, advantageously linearly polarized light, is then passed through the electro-optical light transmitting elements. By means of the properties of the electro-optical light transmitting elements, at least a first and a second signal indicative of the electric fields over the respective electro-optical light transmitting elements are then measured. These first and second signals are periodic functions of the applied voltage. Thus, by combining the at least two signals, the voltage between the first and the second terminal can be derived and ambiguities in the first signal are resolved using the second signal. Therefore, as an advantage over prior art, only one second signal (from one electro-optical light transmitting element) is sufficient to resolve ambiguities in the voltage calculation based on the first signal from the other electro-optical light transmitting element. This results in simpler optics which is cheaper and advantageous in terms of size.

In an embodiment, the first and the second signals have the same periodicity of the voltage V or are scaled such that they have the same periodicity of the voltage. Furthermore, the first and second signals have a relative phase shift other than zero, i.e., the phase of the second signal is shifted with respect to the phase of the first signal. In an embodiment, the nonzero phase shift of the second signal with respect to the first signal is introduced by a phase shifting element which is arranged in an optical path at the second electro-optical light transmitting element. This phase shifting element is, e.g., a $\lambda/4$ retarder and thus a quadrature readout is enabled.

In an embodiment, the phase shift of the second signal with respect to the first signal is dependent on the temperature of the phase shifting element. Thus, in a preferred embodiment, the temperature of the phase shifting element can be derived from the second signal. This derived temperature can then, for example, be used for computational compensation of a temperature dependence of the measured signals and hence for a computational compensation of the temperature dependence of the derived voltage between the first and the second terminal. Thus, a better accuracy can be provided.

In an embodiment, the two signals are based on electric field-dependent changes of a physical property of the light beams, for example, the phase of two orthogonal linearly polarized light waves per electro-optical light transmitting element. Then, e.g. after interference of these light waves at a polarizer at the end of each electro-optical light transmitting element, the resulting light intensity signals are converted to an electrical signal per crystal, e.g., by photodiodes.

In an embodiment, the electro-optical light transmitting elements are arranged in series, i.e. electrically in series (i.e. one after another along the z-axis in a longitudinal or axial direction) between the terminals. Thus, the electric field is distributed over the single electro-optical light transmitting elements, which leads to simpler insulation and cheaper implementation.

The to-be-measured voltage between the terminals is in particular an AC voltage and/or in the high-voltage range, in particular in the range between 75 kV and 800 kV or even more. Thus, voltages in substations of power transmission networks can be measured.

After a first time interval [t1; t2] with voltage ranges leading to a periodicity of the measured signals as functions of the voltage (i.e. the whole period of the measured signals is covered, or, in other words, the measured signals as periodic functions of the voltage reach their maximum and minimum values), an advantageous embodiment of the disclosed method and/or device is also suitable for measuring small voltages during a second time interval [t3; t4]. The term "small voltage" refers to a range of voltages that is too small for the measured signals to reach their maximum and minimum values (i.e. to cover the full period of the measured signals). The capability of measuring small voltages is advantageous in the case of a voltage-drop due to, e.g., a malfunction in the power transmission network. The time gap (t3-t2) between the first time interval and the second time interval is larger than one voltage signal period to enable "small voltage" detection. Then, scale and/or offset parameters that has or have been derived during the first time interval [t1; t2] is or are kept constant for deriving the voltage V between the terminals during the second time interval [t3; t4]. Thus, an accurate deriving of the voltage is possible even for voltage ranges that do not cover the full period of the measured signals.

In an embodiment, only one signal per electro-optical light transmitting element is measured. This results in simpler optics.

In another embodiment, at least one internal parameter $\alpha_n$, e.g. the fraction of the total voltage V that is applied to a single electro-optical light transmitting element (or another value descriptive of a distribution of the voltage over the electro-optical light transmitting elements), is recursively derived based on its most common value. Due to a recursive tracking of the internal parameter $\alpha_n$, its exact values are not needed during a first initialization.

In another preferred embodiment, at least three electro-optical light transmitting elements are arranged in series in the electric field between the terminals and at least three signals indicative of the electric fields over the respective electro-optical light transmitting elements are measured. By combining all signals, the voltage between the first and the second terminal can be derived. In this process, ambiguities in all signals can be resolved.

Furthermore, a device which is adapted to carry out a voltage measurement by means of a method according to the invention is provided.

In summary, in the invention, the step of resolving the ambiguity in the first signal comprises a step of taking a binary decision between two hypotheses. These hypotheses correspond to different possible voltage values given the measured value of the first signal. The binary decision further comprises a derivation of an expected value of the second signal for each of the hypotheses and a comparison of the expected value to a measured value of the second signal. Thus, an unambiguous solution can be found.

Brief Description of the Drawings

The invention will be better understood and objectives other than those set forth above will become apparent when consideration is given to the following detailed description of the invention. This description makes reference to the annexed drawings, wherein:

Fig. 1 (prior art) shows a schematic representation of an optic voltage sensor,

Fig. 2a, 2b, 2c, 2d show different configurations for electro-optical voltage sensors,

Fig. 3 shows an arrangement of two electro-optical light transmitting elements in the electric field between two terminals,

Fig. 4a, 4b show flowcharts of a method for measuring a voltage between a first and second terminal with a plurality of electro-optical light transmitting elements and with a single electro-optical light transmitting element, respectively,

Fig. 5 shows a signal with period numbers, or more precisely a count k of zero crossings,

Fig. 6a, 6b, 6c show disambiguation procedures using a reference or quadrature signal,

Fig. 7 shows a first procedure to measure a phase between a base signal and a reference signal,

Fig. 8 shows a second procedure to measure a phase between a base signal and a reference signal,

Fig. 9 shows an arrangement of three electro-optical light transmitting elements in the electric field between two terminals, and

Fig. 10a, 10b, 10c show a method for an improved reconstructing of a voltage waveform from a base signal and reference signal.

Modes for Carrying Out the Invention

A method and device for measuring a voltage between two terminals, in particular an AC voltage in the high-voltage regime, is disclosed. Advantageously, the method and/or device relies on an electro-optic effect in an electro-optical element. This electro-optic effect introduces, e.g., a different optical phase shift in two perpendicularly polarized light waves that travel through the electro-optical element. Thus, a signal indicative of the electric field at the position or over the length of the electro-optical element can be measured. Ambiguities in the signals are resolved by an additional quadrature signal. By arranging a plurality of these electro-optical elements in series between the terminals, advantages in terms of cost efficiency and insulation are achieved, but resolving the ambiguities of the signals becomes more challenging, particularly for unequal and/or varying voltages over the single electro-optical elements (and consequently unequal periodicity of the measured signals) as well as for varying relative phases of signals.

The invention relates to a method for accurately reconstructing the waveform of the applied voltage between the terminals, may it be the full voltage or a partial voltage or both, using a base signal $S_n$, for example $S_1$, indicative of the electric field over the first electro-optical light transmitting element and a reference signal $S_n'$, for example $S_2$, for resolving the ambiguity in the deriving of the voltage. The method comprises: determining from the first signal $S_n$ at least two hypotheses $h^+$, $h^-$ corresponding to different possible voltage values $V^{h+}$, $V^{h-}$ or $V_n^{h+}$, $V_n^{h-}$, for example $V_1^{h+}$, $V_1^{h-}$, of the voltage $V$ or $V_n$, deriving an expected value $S_n^{h+}$, $S_n^{h-}$, for example $S_2^{h+}$, $S_2^{h-}$, of the second signal $S_n'$ for each of the hypotheses $h^+$, $h^-$, comparing the expected values $S_n^{h+}$, $S_n^{h-}$ to a measured value of the second signal $S_n'$, and taking a binary decision between the hypotheses $h^+$, $h^-$ by validating that hypthesis $h^+$ or $h^-$ for which the expected value $S_n^{h+}$ or $S_n^{h-}$ is closest to the measured value of the second signal $S_n'$.

In an embodiment, exactly one electro-optical light transmitting element 2 is used, and the hypotheses $h^+$, $h^-$ correspond to different possible voltage values $V_1^{h+}$, $V_1^{h-}$ of the full voltage $V$ between the first terminal 1a and the second terminal 1b.

Embodiments disclose a method for accurately reconstructing the waveform of the applied voltage between the terminals using a plurality of electro-optical elements but not requiring a quadrature signal for each electro-optical element. Furthermore, the temperature of the system can be derived from the phase of the quadrature signal and it can be used to compensate for the temperature dependence of the electro-optic effect itself. Furthermore, a method for deriving a small voltage (i.e. the voltage being much smaller than the rated voltage and the electro-optic phase shift being within $\pm180°$) is disclosed. Furthermore, a device for measuring a high-voltage is disclosed.

*Definitions:*

The term "high voltage" designates AC voltages exceeding 1 kV or DC voltages exceeding 1.5 kV and, in particular, voltages exceeding 75 kV.

The terms "radial" and "axial" are understood with respect to the axial direction (parallel to the axis of the light beam hv, z-axis) of the sensor, with "radial" designating a direction r perpendicular to the axial direction and "axial" designating a direction parallel to the axial direction z.

*Description of the invention:*

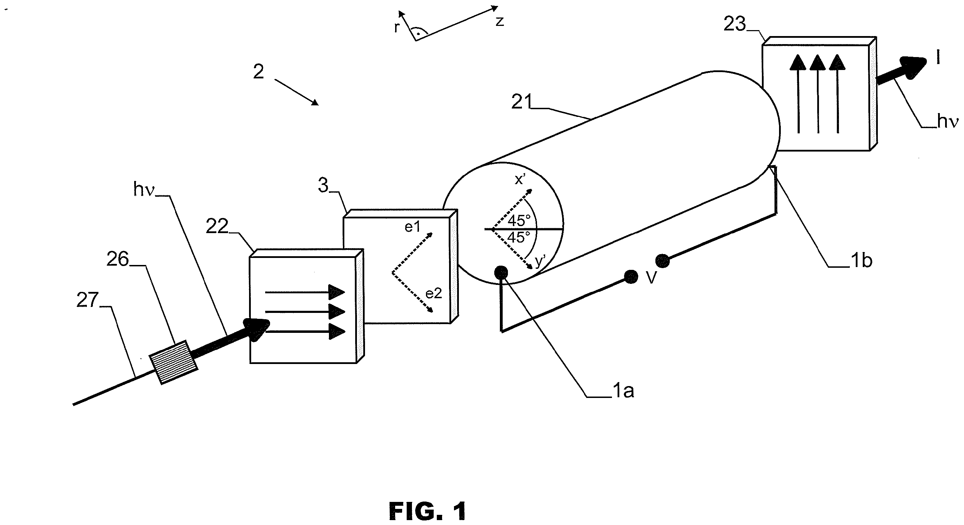

As shown in Fig. 1 (prior art), an electro-optical light transmitting element 2 comprises an optical sensor 21 (e.g. an electro-optic crystal) introducing a field-dependent phase shift between a first polarization or mode and a second polarization or mode of light passing through it. This light can, e.g., be guided to the optical sensor 21 through an optical fiber 27 and a coupling lens 26. Ideally, an electro-optical light transmitting element 2 measures the line integral $\int E^*ds$ of the electric field between two electric potentials 1a, 1b, e.g. ground 1b and high voltage potential 1a. This concept is particularly suited for outdoor installations, e.g. substations in power transmission networks, because the measurement accuracy is not deteriorated by field perturbations, e.g. due to rain or ice or crosstalk from neighboring phases. Electro-optic crystals 21 of certain symmetry are well suited to implement this concept.

An electric field applied to an electro-optical crystal 21 induces an anisotropic change in the refractive index of the material (birefringence). This birefringence (or change of birefringence) causes a phase shift between two orthogonally linear polarized light waves traversing the crystal 21 (Pockels effect). By measuring this phase shift, the applied voltage can be derived. One configuration of an electro-optical light transmitting element 2, which implements line integration of the electric field, is shown in Fig. 1: The voltage $V$ is applied to the end faces of a crystal 21 with the light also entering and leaving the crystal through the end faces. The crystal material and its axis orientation are chosen such that only electric field components $E_Z$ (pointing along the cylinder) contribute to the electro-optic phase shift. One suitable material is $Bi_4Ge_3O_{12}$ (BGO) in a [001] configuration, corresponding to the 4-fold crystal axis being parallel to the direction of light propagation. The input light hv (broad arrow) is linearly polarized by a first polarizer 22 (thinner arrows indicating the direction of a transmitted polarization; the first polarizer 22 may be an in-fiber polarizer, as well). To achieve maximum modulation contrast, the electro-optic axes of the crystal x', y' are preferably oriented under an angle of 45° with respect to the incoming linear polarized light. The phase shift $\Gamma$ between the components of the light with polarizations parallel to x' and y' is caused by the electric field in the crystal 21 and is converted to an amplitude modulation of the transmitted light by a second polarizer 23 arranged at the output end of the crystal 21. To bias the phase shift $\Gamma$, an additional phase shifting element 3 (adding a phase $\varphi$) may be placed in the optical path (between the two polarizers 22, 23). The principal retarder axes e1 and e2 are aligned parallel to the electro-optic axes x' and y' of the crystal 21. In general, the intensity I of the transmitted light after the second polarizer 23 is of the form $I \sim \cos^2(V)$. The retarder 3 is advantageously a $\lambda/4$

waveplate.

For typical voltages V at high-voltage substations, an ambiguous sensor response is usually achieved. This ambiguity is classically resolved by working with two optical output paths per crystal that are substantially $\pi/2$ (90°) out of phase, i.e. that are in quadrature, or that have any other relative phase shift that is not a multiple of $\pi$.

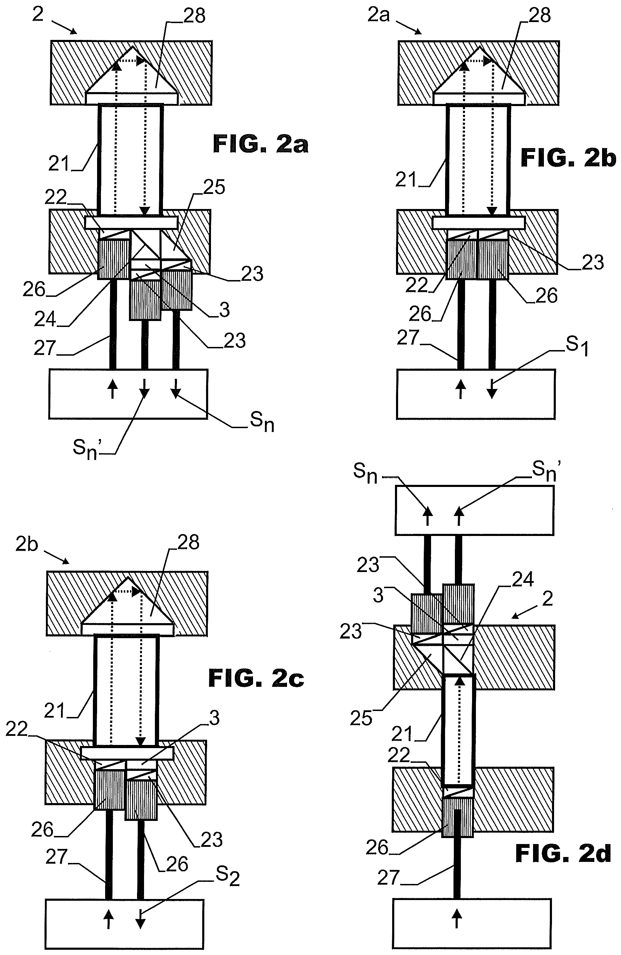

Fig. 2a - 2d show optical sensor arrangements that can be used in the measuring method of the present invention.

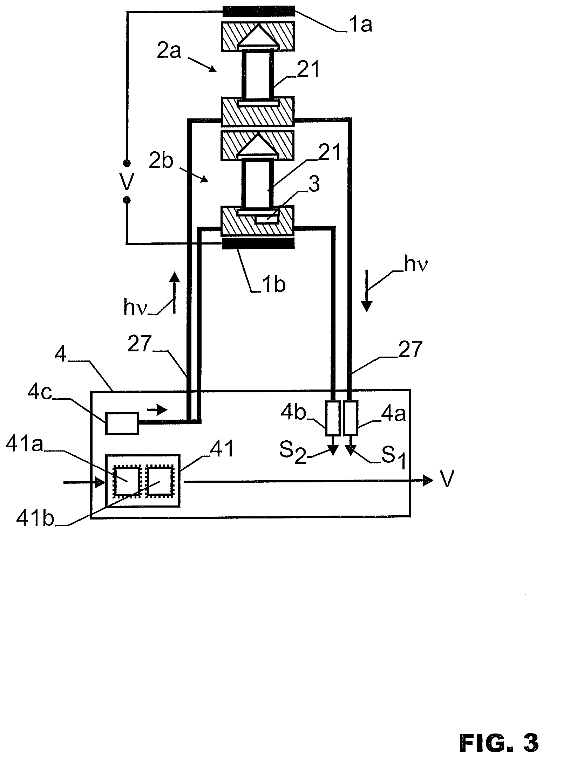

In Fig. 2a, the sensor crystal 21 is used in reflection using a reflecting prism 28, and in Fig. 2d in transmission. The light is transmitted via optical 27, coupling lens 26 and first polarizer 26 into the crystal 21. After the crystal 21, the light is split via beam splitter 24 into two optical paths, namely one path comprising, e.g., a deflection prism 25 and a second polarizer 23 and photodetector 4a (shown in Fig. 3) coupled to the optoelectronic unit, and another path comprising a phase shifting element 3 and a further second polarizer 23 and a further photodetector coupled to the optoelectronit unit 4. Thus, the 90°-phase shift may be generated by splitting the light that leaves the crystal 21 into two paths by means of the beam splitter 24 and the deflection prism 25 and arranging the phase shifting element 3 in one of the paths.

In a voltage sensor comprising at least a first and a second electro-optical light transmitting element 2a and 2b (Fig. 3), a base signal $S_1$ or in general $S_n$ and a quadrature signal $S_1'=S_2$ or in general $S_n'$ may be generated by inserting a phase retarder 3 into the optical path at one of the electro-optical light transmitting elements (here: electro-optical light transmitting element 2b as in Fig. 2c) and operating the other electro-optical light transmitting element(s) (here: electro-optical light transmitting element 2a as in Fig. 2b) without a retarder. As a consequence, there is only one output path per crystal (as in Figs. 2b and 2c). Extra beam splitters 24 and deflection prisms 25 for a quadrature path per crystal 21 (as in Fig. 2a) are thus avoided. As a result the device becomes significantly smaller (and cheaper), which allows to mount the sensing elements in a relatively narrow bore.

In the shown embodiment, light is guided to and from the electro-optical light transmitting elements 2a, 2b through optical fibers 27. The light is usually produced by a light source 4c (e.g. an LED or a laser) inside a light processing module 4 or optoelectronic unit 4. Transmitted light is detected inside the optoelectronic unit 4 by a photodetector 4a, 4b, such as a photodiode, per channel, which means here, e.g., per electro-optical light transmitting element 2a, 2b due to a single path being present per element. Alternatively, the photodetectors 4a, 4b could be integrated into the electro-optical light transmitting elements 2a, 2b themselves. A first and a second signal $S_1$ and $S_2$ , i.e. $S_n$ with n=1 and n=2, which are indicative of the electric field over the respective electro-optical light transmitting element 2a and 2b are thus measured. A control unit 41 (consisting of a CPU 41a and a memory 41b) derives the voltage V between the terminals 1a and 1b based on the signals $S_1$ and $S_2$. During the derivation, ambiguities in a single signal - or, in the case of more than two signals, ambiguities in a subset of the signals - are resolved by the quadrature signal $S_1'=S_2$. In other words, all pairs of measured signals produce an unambiguous output, in particular if one of, preferably exactly one of, the signals is phase-shifted with respect to the other. Therefore, it is possible to measure only one signal $S_1$ and $S_2$ per electro-optical light transmitting element 2a and 2b and nevertheless to arrive at an unambiguous voltage signal V.

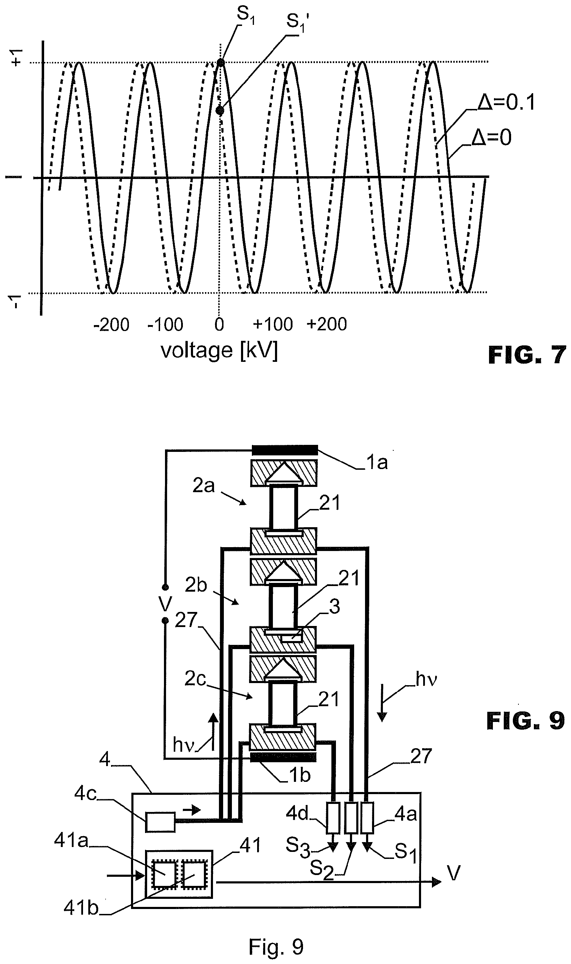

The voltage sensor shown in Fig. 9 is very similar to the voltage sensor discussed above, with the exception that it comprises an additional, e.g. a third, electro-optical light transmitting element 2c from which a third signal $S_3$ is measured via a third photodetector 4d.

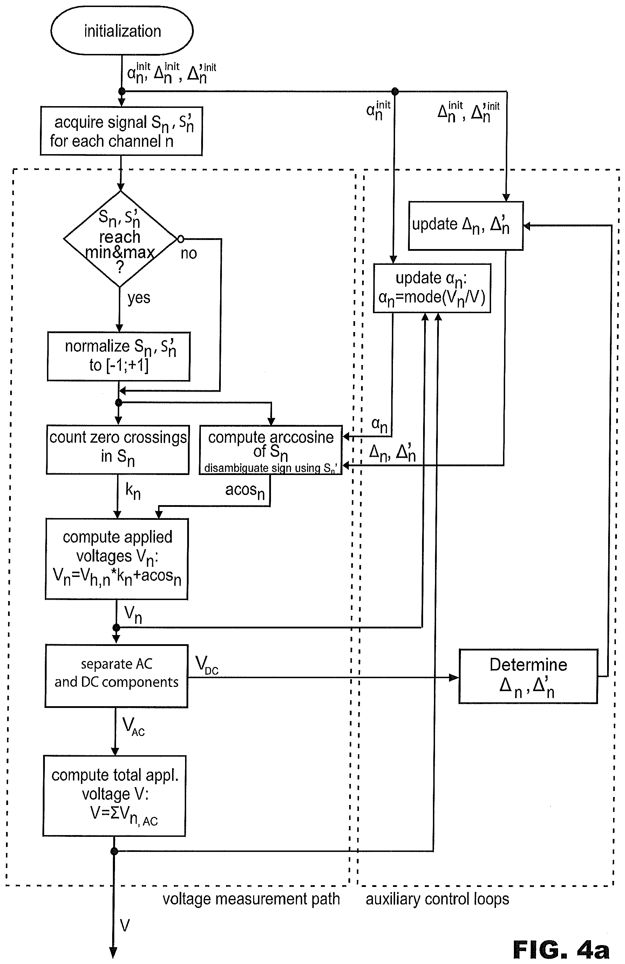

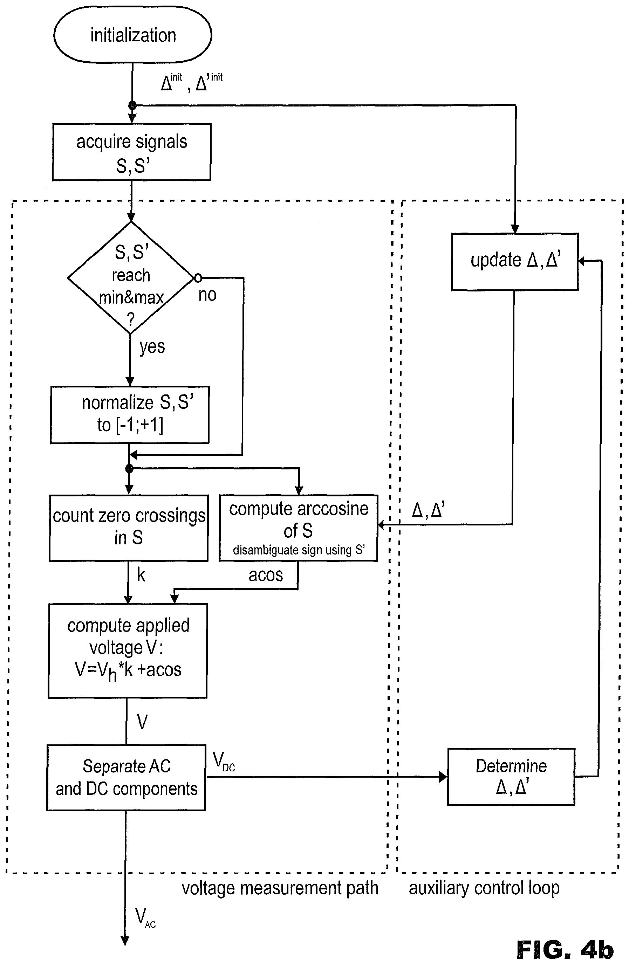

The procedure for accurately reconstructing the waveform of the applied voltage V (even under unequal and varying partial crystal voltages $V_n$, and consequently under unequal periodicity of the optical signals $S_n$) as well as under varying relative signal phases is summarized in Fig. 4a for plural electro-optical light transmitting elements and in Fig. 4b for exactly one such element.

The procedure starts with an initialization stage, where (not necessarily accurate) initial values $\alpha_n^{init}$ and $\Delta_n^{init}$ are set for each electro-optical light transmitting element (see below). These parameters might be determined in a (semi-)automated way or provided manually by the operator. Then, for each measured signal $S_n$ (e.g. from photodiodes 4a, 4b, ...) representing a light intensity level I from each n-th electro-optical light transmitting element 2a, 2b, ..., it is verified whether the applied voltage is "large", i.e. whether the signal(s) $S_n$ reaches a minimum and a maximum, or whether the voltage is equal to or exceeds the half wave voltage or is smaller than the half wave voltage, for example whether an electro-optic phase shift $>\pm 180°$ is induced or, in other words, the absolute value of the electro-optic phase shift exceeds 180°, or "small", i.e. whether the signal (s) $S_n$ does not reach a minimum and a maximum, for example whether the electro-optic phase shift remains within $\pm 180°$ or, in other words, the absolute value of the electro-optic phase shift is smaller than or equal to 180°. When the voltage is "large", the amplitude of the acquired signal $S_n$ is normalized to a given interval, e.g. to the interval [-1;1], in order to eliminate gain and offset differences amongst the channels or paths due to the measurement chain (here e.g. photodiode - amplifier). When the voltage is "small", the signal $S_n$ is not normalized in order to preserve the correct information about amplitude, and thus about the applied voltage (see below). In other words, when the voltage is "small", updating of the normalization parameters, such as gain, offset, etc., is disabled, Therefore, the most recent normalization parameters that had been obtained, i.e. updated, with "large" voltage are used.

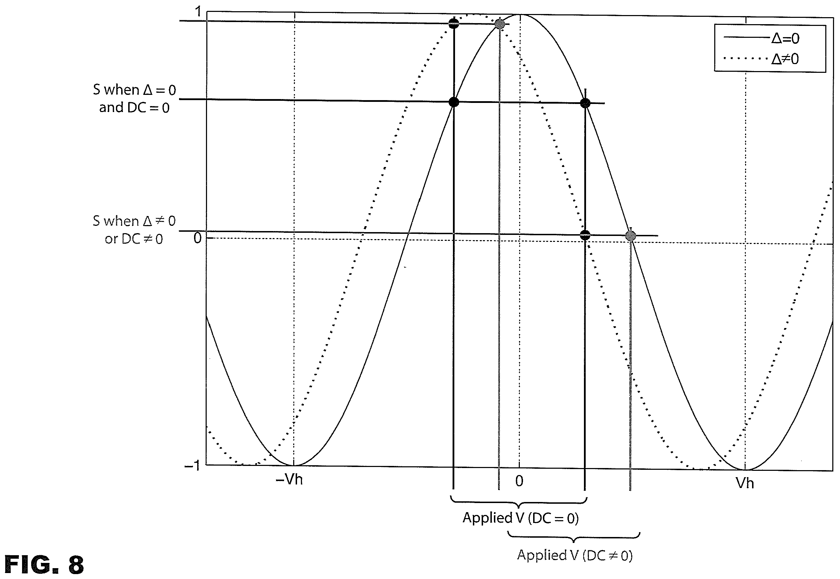

Fig. 4b shows a largely similar procedure for the case of exactly one electro-optical light transmitting element 2, with the same or similar steps being applied as described above. The base signal is designated as S and the reference signal as S'. In particular, $\alpha_n$ are not needed, the initial phase shifts $\Delta_{init}$, $\Delta'_{init}$ of the base signal and reference signal, or their relative initial phase shift $\Delta_{init}$-$\Delta'_{init}$, are used, and the full voltage V can be directly determined without summation over n. In addition, an auxiliary control loop can comprise updating or refining of the phase shifts $\Delta$ and $\Delta'$, or $\Delta$-$\Delta'$, by separating the ac and dc voltage components from each other and calculating $\Delta$ and $\Delta'$, or $\Delta$-$\Delta'$, from the dc component (see Fig. 8). Such updating or refining can be applied both in Fig. 4a and Fig. 4b.

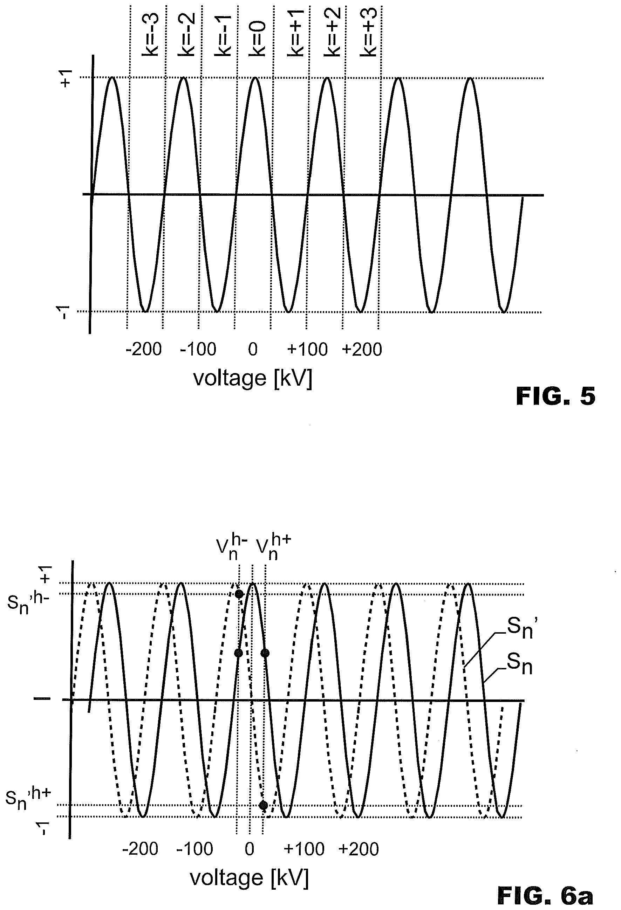

Now continuing with Fig. 4a, the partial voltage $V_n$ applied to each n-th electro-optical light transmitting element 2a, 2b, ... is determined from $S_n$ in two steps: The first step is to count the zero-crossings in $S_n$, as it is illustrated in Fig. 5. This is used to determine the period K of the cosinusoidal response and provides a first, coarse approximation of the applied voltage $V_n$. This approximation can then (if necessary) be refined by computing the remainder or approximation error, which is given by the inverse response (usually the arccosine function) of the sensor. The sum of the zero-crossings approximation and of the remainder gives the applied voltage $V_n$.

The total voltage V between the terminals 1a and 1b is finally given by the sum of all partial voltages $V_n$: In the embodiment of the invention from Fig. 3, the high-voltage sensor is composed of several electro-optical light transmitting elements 2a, 2b. Each electro-optical light transmitting element 2a, 2b can be inserted in an insulator with a central bore containing, e.g., a BGO crystal 21. The total voltage between terminals 1a and 1b is denoted by V. The partial voltage applied to a given electro-optical light transmitting element 2a, 2b, ... is denoted by $V_n$. The total voltage V is then the sum of all partial voltages: $V=\sum V_n$. Conversely, partial voltages $V_n$ are defined by the fraction $\alpha_n$ of the total voltage V that is applied to the corresponding module: $V_n = \alpha_n * V$. As mentioned earlier, partial voltages might differ and vary in time. Therefore, $\alpha_n \neq \alpha_m$ if $n \neq m$ and $\alpha_n = \alpha_n(t)$ may occur. The intensity $I_n$ of the light beam exiting each electro-optical light transmitting element 2a, 2b, ... is given by the following expression:

$$I_n = I_{n,0} \cdot \cos^2\left(\pi\left(\Gamma_n + \Delta_n\right)\right) \qquad (1)$$

$$\Gamma_n = \frac{V_n}{2V_{h,n}} \qquad (2)$$

where $I_{n,0}$ is the intensity of the exiting beam with zero retardation, $\Gamma_n$ expresses the voltage-dependent retardation (field-dependent phase shift) between the two polarized light components when they exit the crystal 21, and $\Delta_n$ is the relative phase of the n-th signal with respect to the applied voltage. $V_{h,n}$ is the half-wave voltage of the BGO crystal 21 in optical channel n. This is the voltage that leads to the retardation of $\Gamma_n=1/2$. In equation (1), it is assumed that the modulation depth of the optical signal is equal to unity. The relative phases $\Delta_n$ of the signals can differ and vary in time depending on temperature, as mentioned earlier. Therefore, $\Delta_n \neq \Delta_m$ if $n \neq m$ and $\Delta_n = \Delta_n(t)$ may occur.

The electrical signals $S_n$ produced by the measurement chain (photodiode - amplifier) is then given by

$$S_n = G_n \cdot I_n + b_n + e_n \qquad (3)$$

where $G_n$ is the cumulated gain of all components in the measurement chain, and $b_n$ is an offset. The term $e_n$ is a noise term.

Measurement of the applied voltage

As mentioned above, in the first signal processing stage (Fig. 4a, 4b), the amplitude of each electrical signal can be normalized to the interval [-1; 1]. This operation eliminates the gain and offset parameters from equation (3) (the noise term $e_n$ has been neglected here):

$$S_n^{Norm} = 2 \cdot \cos^2\left(\pi\left(\Gamma_n + \Delta_n\right)\right) - 1 \qquad (4)$$

Signal normalization is simply achieved by applying the scale and offset factors that map the minimum or maximum of the actual response to the desired, normalized minimum or maximum (i.e., -1 and 1):

$$scale = 0.5 \cdot (\max - \min) \qquad (5)$$

$$offset = \min + scale \qquad (6)$$

$$S_n^{Norm} = \frac{S_n - offset}{scale} \qquad (7)$$

To solve the above equations, both response extrema min (=minimum) and max (=maximum) shall be determined. This means in turn that response normalization can only be done when the electro-optic phase shift induced by applied voltage between the terminals 1a and 1b is above ±180°, i.e. a "large" voltage is measured. Otherwise, the scale and offset factors must be kept constant until the above condition is fulfilled again (see "Measurement of small voltages" below). In the second stage, all partial voltages $V_n$ are determined by solving equations (1) - (4) for $V_n$. This leads to

$$V_n = \frac{V_{h,n}}{\pi}\left(\left(\pm \arccos\left(\frac{2(S_n - b_n)}{G_n \cdot I_{n,0}} - 1\right) + K \cdot 2\pi\right) - 2\pi\Delta_n\right) \qquad (8)$$

Note that after signal normalization, $G_n=1$ and $b_n=0$. In equation (8), it is apparent that due to the periodicity of the (arc-)cosine, $V_n$ can only be resolved up to the factor $2*K*V_{h,n}$ when K = number of periods is unknown. In order to determine K, i.e. the period of the cosinusoidal response of the electro-optical light transmitting element that corresponds to the applied voltage $V_n$, a bidirectional count k of the number of zero crossings of the measured signal $S_n$ is used. In fact, the number k of zero crossings changes twice per period K. The zero-crossings counting procedure is derived from US 5'001'419, which in its entirety is herewith made part of the disclosure by reference. Two optical signals at quadrature are considered: The count k is incremented as the voltage waveform represented by the base signal is becoming more positive and is decremented as the magnitude of the represented waveform is becoming more negative. The base signal is the signal for which the parameter of interest, e.g. here the number of zero crossings, is determined. The quadrature signal is another signal - in our case from a different electro-optical light transmitting element 2a, 2b, ... - that has been delayed with respect to the base signal, e.g. by using a phase shifting element 3. The direction in which the waveform is moving is determined by which of the signals (base signal or quadrature signal) is leading. Reversal of the direction of the voltage waveform results in a switch in which one signal is leading and can therefore be detected by two consecutive zero crossings in the same signal.

In order to avoid random indexing of the bidirectional cumulative count k of zero crossings, which could occur with small signals, a dead band is created around the zero axis. Zero crossings are not counted while the signal is in this dead band. Instead, a determination is made when the signal again leaves the dead band as to whether the zero crossings should be indexed:

- If the signal exits the dead band on the same side that it entered, then the target signal has changed direction and k should not be indexed;
- if the signal exits the dead band on the opposite side from which it entered, then there has been a zero crossing and k is indexed.

Note that if the zero crossings counter k can be set to zero when the voltage is zero, then subsequent voltage measurements will be correct. In general, however, the voltage at startup (during the initialization) is not known and therefore k is arbitrary. Under the assumption that the applied voltage is purely AC, k can be adjusted in integer steps until the average value of the calculated voltage over one cycle is zero. After k has been properly adjusted, the calculated voltages will be correct until the program is interrupted.

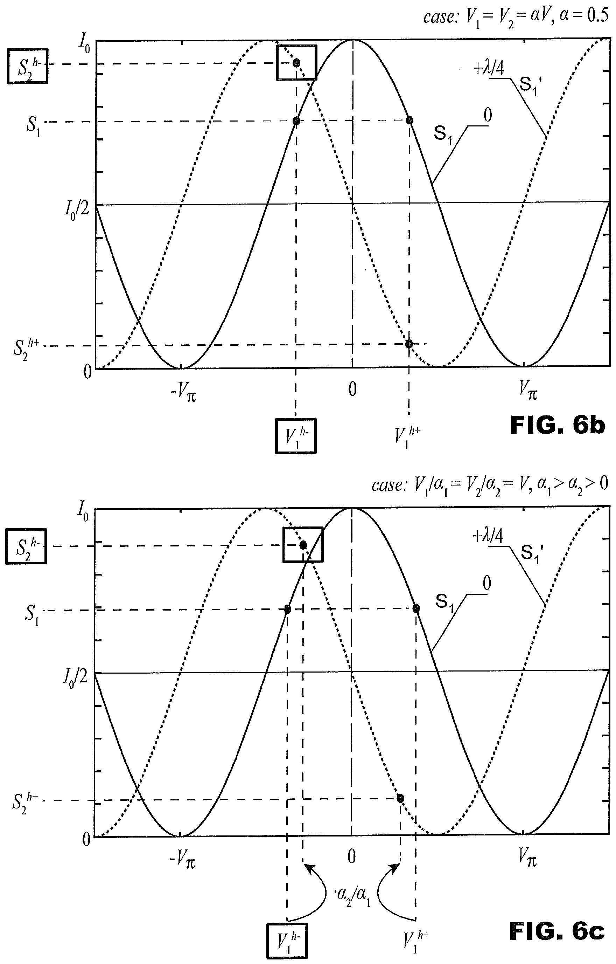

It is apparent in equation (8) that measured voltage $V_n$ is given by the sum of two distinct terms. The first term, $K*2\pi$, is approximated using cumulative zero crossings counting as discussed above. Computation of the second term, $\arccos(2(S_n-b_n)/(G_n*I_{n,0})-1)$, will be discussed next: Fundamentally, equation (8) must be solved for $V_n$ given the signal $S_n$, with period number K known from zero-crossings counting k. The sign of the arccosine cannot be determined from $S_n$ alone. Therefore, the quadrature signal is additionally used in order to disambiguate the sign. The corresponding procedure is illustrated in Fig. 6a, and in even more detail in Fig. 6b and 6c. Fig. 6a shows the base signal $S_1$, or more general Sn, with zero phase shift $\Delta=0$ and the reference signal $S_1'$, or more general $S_n'$, with ideal quadrature phase shift $\Delta'=90°$, both normalized to a range [-1; +1], as a function of the high voltage in kilovolt. Fig. 6b and 6c show the corresponding raw base signal $S_1$ and raw reference signal $S_1'$ oscillating between zero and maximum light intensity $I_0$, or optical power respectively, around a medium light power $I_0/2$. As a remark, in this case, the count k of zero crossings, or equivalently periods, would correspond to counting crossings of the medium light power $I_0/2$.

Fig. 6b shows the case of two identical crystals 21 or identical electro-optical light transmitting elements 2a, 2b exposed to the same partial voltages $V_1 = V_2 = V/2$ and the base signal $S_1$ derived from one of them and the reference

signal $S_1$' from the other, or equivalently the case of one crystal 21 or one electro-optical light transmitting element 2 with both base signal $S_1$ and reference signal $S_1$' derived therefrom. The x-axis shows the voltage V normalized to the half wave voltage $V_\pi$. The signal $S_1$ is basis for two hypthetic reference voltages $V_1^{h-}$ and $V_1^{h+}$, of which $V_1^{h-}$ is validated by finding most similarity of closeness of the corresponding hypothetic reference signal $S_2^{h-}$ with the measured reference signal $S_1$'=$S_2$.

Fig. 6c shows the case of two crystals 21 or electro-optical light transmitting elements 2a, 2b exposed to different partial voltages $V_1$, $V_2$, i.e. with different $\alpha_1$ and $\alpha_2$. The base signal $S_1$ is derived from one of them and the reference signal $S_1$' from the other. The x-axis shows the voltage V normalized to the (common) half wave voltage $V_\pi$. The broadened signal $S_1$ is basis for two hypthetic reference voltages $V_1^{h-}$ and $V_1^{h+}$, derived from the relevant $S_1$ values (full dots) by multiplying with the ratio $\alpha_2/\alpha_1$, of which $V_1^{h-}$ is validated by finding most similarity or closeness of the corresponding hypothetic reference signal $S_2^{h-}$ with the measured reference signal $S_1$'=$S_2$.

In more detail, two hypotheses $h^+$ and $h^-$ are generated:

$$h^+ : V_n^{h+} \propto + \arccos(\cdot)$$

$$h^- : V_n^{h-} \propto - \arccos(\cdot)$$

The voltage $V_n$ under both hypotheses, $V_n^{h+}$ and $V_n^{h-}$, is then calculated using equation (8). Subsequently, the quadrature signal response under both hypotheses, $S_{n'}^{h+}$ and $S_{n'}^{h-}$, is computed. This is done by inserting $V_n^{h+}$ and $V_n^{h-}$ into the following expression, derived from equations (1) - (4):

$$S_{n'}^h = G_{n'} \cdot I_{n',0} \cdot \cos^2\left( \pi \left( \frac{V_{n'}^h}{2V_{h,n'}} + \Delta_{n'} \right) \right) + b_{n'} \qquad (9)$$

Note that in equation (9), n' is the index of the quadrature signal (e.g., n'=2) that is used to disambiguate the sign, not the index n of the signal whose voltage is computed: n'≠n. Finally, the hypothesis with the calculated quadrature signal response $S_n^h$ (expected value) that is closest (in terms of Euclidean distance) to the measured quadrature signal response $S_{n'}$ is validated.

As mentioned above, the sign of the arccosine is disambiguated by "projecting" both voltages $V_n^{h+}$ and $V_n^{h-}$ onto the quadrature response in order to verify which hypothesis produces an image that matches the measured quadrature signal most closely. Since it is possible that the voltage fractions applied to the base path and to the quadrature path differ ($\alpha_n \in [0;1]$), it is necessary to to convert from the voltage over one element to the voltage over the other element prior to comparison. This is achieved by expressing one response as a function of the other one:

$$V_n = \alpha_n \cdot V$$
$$V_{n'} = \alpha_{n'} \cdot V$$

$$\Rightarrow V_{n'} = \frac{\alpha_{n'}}{\alpha_n} \cdot V_n \qquad (10)$$

Determination of the alphas

It has been mentioned earlier that partial voltages might be unequal and varying in time. I.e., $\alpha_n \neq \alpha_m$ if n≠m and $\alpha_n = \alpha_n(t)$. The partial voltage applied to each electro-optical light transmitting element 2a, 2b, ... can be determined by rewriting the definition of $\alpha_n$:

$$\alpha_n = \frac{V_n}{V} \qquad (11)$$

In equation (11), $\alpha_n$ is calculated using the measured partial voltages $V_n$ and the total voltage V. On the other hand, the $\alpha_n$ must be known in order to compute $V_n$, and thus V, using equation (8). This means that in general, $\alpha_n$ must

be known in order to compute $V_n$ and $V$, and the voltages are required to compute $\alpha_n$.

However, this apparent contradiction is loosened by observing that in the measurement of the applied voltage, the purpose of $\alpha_n$ is only to disambiguate the sign of the arccosine. Specifically, compensation for different $\alpha_n$ is done prior to the data association step illustrated in Figs. 6a, 6b, 6c. Since the outcome of this step is a binary decision, i.e. positive or negative sign, the decision will be correct even with slightly erroneous $\alpha_n$ as long as the measured quadrature signal response $S_{n'}$ is "much closer" to one calculated signal response $S_n{}^{,h}$ than to the other one.

With AC voltage, the above observation implies that most of the time (or equivalently, for most voltages $V_n$), the $\alpha_n=f(V_n(t))$ calculated using equation (8) will be correct. $\alpha_n$ will only be erroneous when $V_n$, and thus $V$, is wrong due to an incorrect hypothesis selection. Therefore, $\alpha_n$ is correct "most of the time" or, equivalently, the correct $\alpha_n$ is given by most common value or *mode* of $\alpha_n$.

$\underline{\alpha_n\ \text{tracking control loop}}$

Normally, the exact $\alpha_n$ are not known during initialization. In fact, they are usually not known at any time because $\alpha_n$ depend on stray fields, mechanical variations of the sensor, etc. Therefore, the auxiliary control loop should be initialized with an estimate of $\alpha_n$ for all optical channels n. Then, a first series of measurements is taken and based on the resulting $V_n$, more exact $\alpha_n$ are calculated using equation (11) and the mode of the $\alpha_n$. These new estimates of $\alpha_n$ are used for the following calculations of $V_n$, which are in turn used to refine $\alpha_n$, etc. Thus, $\alpha_n$ are converging.

The above describes an auxiliary control loop that tracks the $\alpha_n$ based on incoming voltage measurements. The optimal refresh rate of the control loop must be determined experimentally; however, it is expected to correspond to a few periods of the applied (AC) voltage.

Measurement of delta and extraction of the retarder temperature

The actual retardation introduced by the phase shifting element 3 varies (approximately linearly) with temperature, whereas the temperature dependence of the phase of the optical channels without retarder is weak. Therefore, the temperature of the retarder can be extracted from the phase difference between the quadrature signal $S_n$' (with phase shifting element 3) and the base signal $S_1$ (without retarder). This information will in turn be used to compensate the sensor output for the temperature dependence of the electro-optic effect.

In order to measure the relative signal phase $\Delta_n$ for any channel n, equation (8) is solved for $\Delta_n$ when $V_n=0$ (therefore, k=0), as illustrated e.g. in Fig. 7, or alternatively in Fig. 8 (see below). With the normalized signal ($G_n=1$ and $b_n=0$), this leads to the following expression:

$$\Delta_n = \pm\frac{V_{h,n}}{2\pi^2}\arccos\left(\frac{2(S_n)}{I_{n,0}}-1\right) \qquad (12)$$

Solving equation (8) when $V_n=0$ is useful because at this specific point, the response is dependent on the relative phase $\Delta_n$, but not on the applied voltage fraction $\alpha_n$. However, this implies that the right time instant (sample) must be determined when $V_n=0$.

The procedure to find this time instant when $V_n=0$ is summarized next: First, the returning points R1 and R2 of the applied voltage can be located under the assumption that the excitation signal is purely AC (i.e. mean value=0). This is a reasonable assumption under normal operating conditions; whenever the assumption does not hold, computation of $\Delta_n$ is temporarily disabled. DC components in the applied voltage can be detected by computing the mean value of the reconstructed voltage V over one or several periods.

An easy way to locate R1 and R2 is to scan the response signal for two successive extrema which are equal to neither 0.5 nor -0.5. However, this does not work for certain values of input signal amplitudes.

An alternative method to locate the returning points R1 and R2 is to use the zero crossings count output k. The returning points R1 and R2 are located on the extrema (either minimum or maximum, determined, e.g., by second derivative) of the measured signal (base or quadrature) that are located within the time period where the counter output *k* is maximal or minimal. These extrema of *k* indicate the returning points of the applied voltage *V,* since *k* is an approximation of *V.*

In Fig. 8 an alternative method to measure a relative phase $\Delta$ between a base signal and the applied voltage V is shown. In an ideal optical voltage sensor, the two optical signals that are produced by the sensor are in exact quadrature. Usually, the base signal S has a phase shift $\Delta=0°$, whereas the reference signal S' is given a phase shift $\Delta'=90°$ by inserting a quarter-wave retarder in the corresponding optical path. In real systems, the phase shifts are generally not equal to their ideal values $\Delta=0$ and $\Delta'=90°$. This is due to temperature dependencies and inaccuracies of the quarter-wave retarder as well as other physical effects. Thus in order to insure accurate reconstruction of the applied voltage, the real phase shifts $\Delta$ and $\Delta'$ must be determined.

The proposed procedure for determining phase shifts is based on the following observation: the effect on the intensity signal S of a non-zero phase shift $\Delta \neq 0$ is identical to the effect of an applied voltage with non-zero DC component $DC \neq 0$. This is illustrated in Fig. 8. A pure AC voltage (DC=0) is applied to both optical paths with $\Delta=0$ and with $\Delta \neq 0$. The resulting intensity signal S is shown in black for $\Delta=0$ and in grey for $\Delta \neq 0$, respectively. Furthermore, the intensity signal with $\Delta=0$ for an applied voltage is not pure AC (DC$\neq$0) is plotted in grey. Clearly, the grey signal due to the non-zero phase shift and the grey signal due to the DC component in the applied voltage are identical.

If it is now assume that the actual applied voltage is purely AC, then any DC offset that is apparent in the reconstructed voltage must be entirely due to the phase shift $\Delta \neq 0$. Therefore, the phase shift can be determined by:

Determining the apparent DC offset in the reconstructed voltage V by computing DC=mean ($V_{reconstructed}$), and
Calculating the corresponding phase shift $\Delta$:

$$\Delta = \frac{DC * \pi}{V_h}$$

with $V_h$ = half wave voltage. The same procedure can be applied to determine the phase shift $\Delta'$ of the reference signal S' with respect to the applied voltage V.

Measurement of small voltages

The invention also provides a mechanism for determining the applied voltage V between the terminals 1a and 1b in cases where the voltage V is much smaller than the rated voltage and the electro-optic phase shift is therefore within $\pm 180°$. Specifically, the measurement of voltages that lead to phase shifts smaller than or within $\pm 180°$ is identical to large voltages (as described above), but with two differences:

- No signal normalization. Phase shifts smaller than or within $\pm 180°$ lead to signals that do not cover the entire possible output amplitude range. I.e., the intensity I of the light beam exiting the electro-optical light transmitting element 2a, 2b, ... as given by equation (1) does not cover the entire admissible range [0; $I_{n,0}$]. Therefore, updating of signal normalization must be disabled in order to preserve the correct information about signal amplitude, and thus about the applied voltage.
- No measurement of delta. Since the estimation of $\Delta_n$, and thus of the temperature, relies on zero-crossings in the response signal, this cannot be performed when the electro-optic phase shift is within $\pm 180°$.

To detect voltages V with phase shift below or within $\pm 180°$, one cannot rely on the voltage measurement itself, because this is obviously only available after signal normalization has been done. Instead, one relies on the scale and offset factors produced by the normalization procedure in equations (5)-(6) when the voltage was still "large". In fact, in a first time period [t1; t2] with t2>t1 the phase shift must be above or outside $\pm 180°$ (i.e., full output amplitude range covered, "large" range of voltages applied to the terminals 1a and 1b). Then, scale and offset remain approximately constant. When in a second time period [t3; t4] (with t4>t3), the phase shift drops below or within $\pm 180°$, at least one of these factors would change rapidly (i.e., within one period of the voltage V), because the signal $S_n$ needs to be rescaled.

Therefore, the voltage V or $V_n$ is considered "small" (phase shift < $\pm 180°$) when either

$$scale(t) - scale(t - \Delta) > \delta_{scale} \qquad (14)$$

or

$$offset(t) - offset(t - \Delta) > \delta_{offset} \qquad (15)$$

Here, $\delta_{scale}$ and $\delta_{offset}$ are threshold values that are used to detect significant or rapid changes in the corresponding parameters. $\Delta$ is the time interval that separates two consecutive evaluations of scale and/or offset. (Note: time interval $\Delta$ does not refer to a phase shift here!). For proper operation of the method, this time interval $\Delta$ must be small enough to ensure proper reaction time (no slowly changing voltages), but larger than one signal period (i.e. 20 ms at 50 Hz or 16.6 ms at 60 Hz).

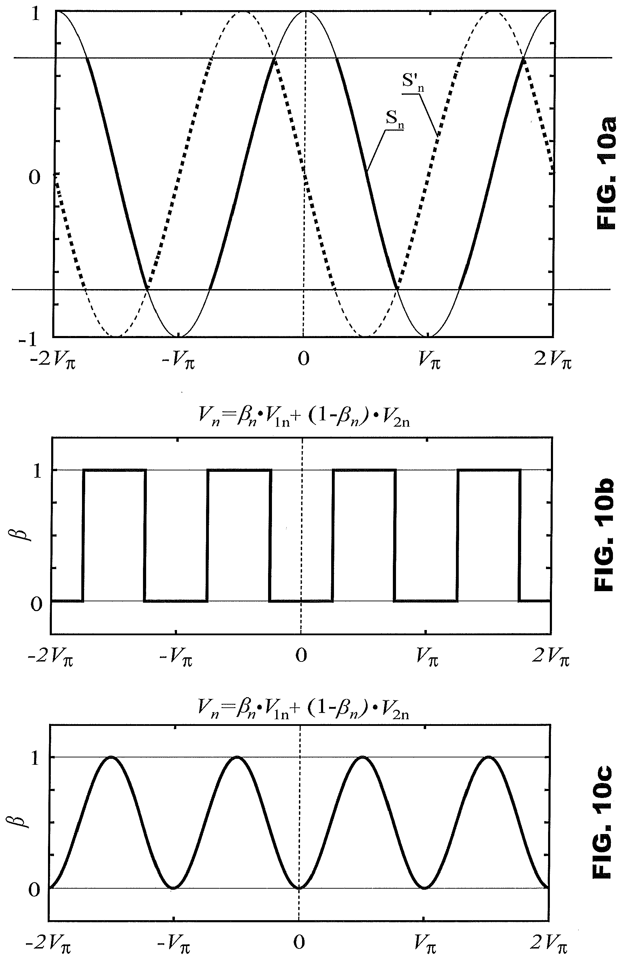

Fig. 10a, 10b, 10c show in another aspect of the invention a method to improve the voltage waveform reconstructed from a base signal and reference signal.

Fig. 10a shows the sensor response (solid line: base signal $S_n$, dotted line: reference quadrature signal $S_n{}'$) normalized to [-1, 1] for the ideal case where the phase shift between the two signals is $\lambda/4$.

If only one of the two signals is used for the voltage reconstruction, one ends up with regions of high sensor sensitivity, e.g. around $\pm V_\pi/2$ for the base signal $S_1$, and regions where the sensitivity is low, e.g. near 0 V or $\pm V_\pi$. If the sensitivity of the sensor is low, even a small measurement error of the light intensity, e.g. due to noise or any error in signal normalization, will translate to a large error in the reconstructed voltage. It is thus of advantage to avoid using these regions of low sensitivity for voltage reconstruction.

The bold lines in Fig. 10a show the signal which has a higher sensitivity in a certain voltage region. Due to the nature of the signal response it is always that signal which is smaller in magnitude and thus closer to the linear region of the cosine function.

• Improved reconstruction using the more linear signal

Therefore, one embodiment is to reconstruct the voltage using always the "more linear" signal, i.e. the bold signal in Fig. 10a. The formula shown in Fig. 10b can be used. The parameter $\beta_n$ can be chosen to be either 0 or 1, depending on which signal has the smaller magnitude. Thus, either the voltage reconstructed by the base signal $S_n$ alone ($\beta_n = 1$) or by the quadrature signal $S_n{}'$ alone ($\beta_n = 0$). This significantly improves the quality and accuracy of the reconstructed voltage waveform as the regions of low sensor sensitivity are avoided.

The method also works for cases where the phase shift between the two signals $S_n$, $S_n{}'$ differs significantly from $\lambda/4$. Note that the voltage is still reconstructed using an arccosine function, and hence no approximations are used in contrast to the prior art.

• Improved reconstruction using a weighted average for two signals

In the improved reconstruction method using the more linear signal described above we end up with a sudden switch between the base and reference signals $S_n$, $S_n{}'$ used for reconstruction. This can cause discontinuities in the reconstructed voltage waveform. In particular, the errors caused for example by an erroneous normalization tend to have an opposite sign for the two signals $S_n$, $S_n{}'$ near the location where one switches from one to the other signal.

By mixing the results from the reconstruction of both of the channels, such discontinuities can thus be removed and, in addition, such errors of opposite sign can be compensated for. For this purpose, the formula in Fig. 10c can be used by replacing the square function for the parameter $\beta_n$ with a function, which continuously oscillates between 0 and 1, in particular $\beta_n = \cos^2(S_n{}^*\pi/2)/(\cos^2(S_n{}^*\pi/2)+\sin^2(S_n{}'^*\pi/2))$. In Fig. 10c this parameter $\beta_n$ is correspondingly represented exemplarily by a $\sin^2(V_n{}^*\pi/V_\pi)$ function of the applied voltage, but it could also be a triangular curve or a more complex curve with steeper edges and flatter minima and maxima as a function of voltage. Herein, $V_n$ = voltage over the n-th electro-optical light transmitting element and $V_\pi$ = half-wave voltage, for example $V_\pi = V_{h,n}$ = half-wave voltage of the crystal in the nth electro-optic light transmitting element.

Notes:

Figs. 2a - 2c show arrangements where the electro-optical light transmitting elements 2, 2a, 2b are operated in reflection mode using a reflector 28, i.e., the light passes the optical sensor 21 twice. Alternatively, the electro-optical light transmitting element 2 may also be operated in transmission mode as in Fig. 1 or Fig. 2d, i.e. the light passes the crystal 21 only once.

Another option to remove the ambiguity instead of or additionally to using a quadrature signal is to operate the sensor with light of two different wavelengths.

The embodiments described here refer to one, two or three electro-optical light transmitting elements. It should be noted, however, that the method and/or device according to the invention is or are suitable for any number of electro-optical light transmitting elements greater than one or two and/or more than two measured signals. The measured signal from any electro-optical light transmitting element can be used to disambiguate the signal(s) from any other electro-optical light-transmitting element(s), in particular if at least one measured signal is phase-shifted with respect to the other measured signal(s) (e.g., one element has a phase shifting element, the other one(s) not).

The role of "base" and "quadrature" signals in this invention is interchangeable, i.e., the quadrature signal can be used to resolve ambiguities in the derivation of the voltage from the base signal, and/or the base signal can be used to resolve ambiguities in the derivation of the voltage from the quadrature signal.

It should be noted that the described hypotheses-method in the "Measurement of the applied voltage"-section is in principle also suitable for disambiguating a "base" signal with a "quadrature" signal in a sensor in which both signals originate from the same electro-optical light-transmitting element, e.g. a classical sensor in which two paths (one without and one with a quarter-wave retarder) are read out from the same electro-optical light-transmitting element.

Throughout this application, the index n shall designate the numbering of the electro-optical light transmitting elements. The index n is an integer that runs from n=1, 2, 3, ....

Optical channel n corresponds to the n-th electro-optical light transmitting element 2, 2a, 2b, 2c, ... of the voltage sensor. The n-th element 2, 2a, 2b, 2c, ... or, e.g., n-th crystal 21 is subject to and is measuring the n-th partial voltage $V_n$, and in the case of exactly one element 2, the full voltage $V=V_1$.

Splitting into two optical paths corresponds to creating a base signal $S_1$ and a reference signal $S_1'$. In general for n optical channels, splitting into two optical paths for the n-th channel corresponds to creating a base signal $S_n$ and a reference signal $S_n'$. These base signal $S_1$ or generally $S_n$ and reference signal $S_1'$ or generally $S_n'$ may be generated from the same electro-optic light transmitting element 2, 2a, 2b, 2c or same crystal 21, or from different light light transmitting elements 2, 2a, 2b, 2c or crystals 21. For example, one may generate base signal $S_1$ from the first element and reference signal $S_1'=S_2$ from the second element, or base signal $S_2$ from the second element and reference signal $S_2'=S_1$ from the first element, or both base signal $S_1$ or generally $S_n$ and reference signal $S_1'$ or generally $S_n'$ from the same element n=1 or generally n. The base signal $S_1$ or generally $S_n$ is the one that is disambiguated with the help of the reference signal $S_1'$ or generally $S_n'$ using the hypthesis tests according to the invention. The n-th base signal $S_n$ is indicative of the voltage V or partial voltage $V_n$ over the n-th electro-optical light transmitting element. However, in particular when both base signal $S_1$ or generally $S_n$ and reference signal $S_1'$ or generally $S_n'$ are derived from the same electro-optical light transmitting element, both the base signal $S_1$ or generally $S_n$ and the reference signal $S_1'$ or generally $S_n'$ may be used in reconstructing an improved waveform of the full voltage V or partial voltage $V_n$.

Please note, that the naming of the electro-optic light transmitting element 2, 2a, 2b, 2c as "first", "second" etc. need not correspond to the index "n" being 1 or 2 etc, because at least one "first" element may be present. As well, the naming of the signals as "first", "second" etc. need not correspond to the index "n" being 1 or 2 etc, because at least one "first" signal may be present.

Furthermore, the mentioned base signals $S_n$ and reference signals $S_n'$ shall be raw signals or partially normalized signals (e.g. offset to be symmetric relative to a zero line, or scaled in amplitude) or fully normalized signals (e.g. offset and scaled to a value range [-1; +1]), as it may be needed or appropriate for the method step under consideration.

In an embodiment, the method further comprises the steps of:

arranging at least a third electro-optical light transmitting element 2c in the electric field between the first 1a and the second terminal 1b,

passing light through the third electro-optical light transmitting element 2c,

measuring at least a third signal $S_3$ from the third electro-optical light transmitting element 2c wherein the third signal $S_3$ is indicative of the electric field over the third electro-optical light transmitting element 2c, and wherein the third signal $S_3$ is a periodic function of the voltage V,

deriving the voltage V from the first signal $S_n$, the second signal $S_n'$, and the third signal $S_3$, wherein the second signal $S_n'$ is used to resolve an ambiguity in the deriving of the voltage V using the first $S_n$ and the third signal $S_3$.

Reference numbers

**[0105]**

| | |
|---|---|
| 1a, 1b: | terminals |
| 2, 2a, 2b, 2c: | electro-optical light transmitting element (sensor module) |
| 3: | phase shifting element |
| 4: | light processing module, optoelectronic unit |
| 4a, 4b, 4d: | photodetector |
| 4c: | light source |
| 21: | optical sensor, e.g. electro-optic crystal |
| 22: | first polarizer |
| 23: | second polarizer |
| 24: | beam splitter |
| 25: | deflection prism |
| 26: | coupling lens |
| 27: | optical fiber |
| 28: | reflector |
| 41: | control unit |
| 41a: | central processing unit (CPU) |

41b:              memory
$S_1, S_2, S_3, S_n$:  signals
$S_n$:             base signal of n-th element or channel
$S_n$':            reference signals of n-th element or channel
V:                voltage
I:                intensity

## Claims

1. A method for measuring a voltage ($V$, $V_n$), in particular a full voltage ($V$) and/or a partial voltage ($V_n$), between a first terminal (1a) and a second terminal (1b), wherein the first terminal (1a) is spatially separated from the second terminal (1b) and wherein the voltage ($V$, $V_n$) creates an electric field between the terminals (1a, 1b), the method comprising the steps of arranging at least one first electro-optical light transmitting element (2, 2a) in the electric field between the first (1a) and the second terminal (1b),
   passing light through the first electro-optical light transmitting element (2, 2a),
   measuring at least one first signal ($S_n$) from the first electro-optical light transmitting element (2, 2a) and further measuring a second signal ($S_n$') from a second electro-optical light transmitting element (2, 2a, 2b, 2c), wherein both signals ($S_n$, $S_n$') are periodic functions of the voltage ($V$) and have a relative phase shift other than zero,
   deriving the voltage ($V$, $V_n$) and resolving an ambiguity in the deriving of the voltage ($V$, $V_n$) from the first ($S_n$) and the second signal ($S_n$'), **characterized by** the steps of:

   (i) using the first signal ($S_n$) as a base signal ($S_n$) indicative of the electric field over the first electro-optical light transmitting element (2, 2a),
   (ii) using the second signal ($S_n$') as a reference signal ($S_n$') for resolving the ambiguity in the deriving of the voltage ($V$, $V_n$),
   (iii) determining from the first signal ($S_n$) at least two hypotheses ($h^+$, $h^-$) corresponding to different possible voltage values ($V_n^{h+}$, $V_n^{h-}$) of the voltage ($V$, $V_n$),
   (iv) deriving an expected value ($S_n^{h+}$, $S_n^{h-}$) of the second signal ($S_n$') for each of the hypotheses ($h^+$, $h^-$),
   (v) comparing the expected values ($S_n^{h+}$, $S_n^{h-}$) to a measured value of the second signal ($S_2$), and
   (vi) taking a binary decision between the hypotheses ($h^+$, $h^-$) by validating that hypothesis ($h^+$, $h^-$) for which the expected value ($S_n^{h+}$, $S_n^{h-}$) is closest to the measured value of the second signal ($S_n$'),

   wherein a waveform of the applied voltage ($V$) between the first terminal (1a) and the second terminal (1b) is reconstructed using a plurality of electro-optical light transmitting elements (2a, 2b) without requiring a quadrature signal for each electro-optical light transmitting element (2a, 2b),
   wherein the electro-optical light transmitting elements (2a, 2b) are arranged in series in an axial direction between the terminals (1a, 1b), and
   wherein further only one signal ($S_n$) per electro-optical light transmitting element (2, 2a, 2b) is measured.

2. The method of claim 1, wherein exactly two hypotheses ($h^+$, $h^-$) are determined and exactly one reference signal ($S_n$') per base signal ($S_n$) is used, and/or wherein closeness of the expected values ($S_n^{h+}$, $S_n^{h-}$) to the measured value ($S_n$') is determined using Euclidean distance.

3. The method of any of the preceding claims, wherein the first signal ($S_n$) and the second signal ($S_n$') have the same periodicity of the voltage ($V$).

4. The method of any of the preceding claims, wherein the relative phase shift between the first signal ($S_n$) and the second signal ($S_n$') is introduced by a phase shifting element (3) that is arranged in an optical path in the second electro-optical light transmitting element (2b), in particular wherein the phase shifting element (3) is a $\lambda/4$ retarder.

5. The method of any of the preceding claims, wherein the relative phase shift between the first signal ($S_n$) and the second signal ($S_n$') is different from 90°.

6. The method of claim 5, wherein the relative phase shift between the first signal ($S_n$) and the second signal ($S_n$') is a function of temperature of the phase shifting element (3), and the temperature of the phase shifting element (3) is derived from the second signal ($S_n$').

7. The method of any of the preceding claims, in particular
wherein the voltage is in the high-voltage range and/or the voltage is an AC-voltage, wherein the first signal ($S_n$) and the second signal ($S_n'$) are based on an electric field-dependent change of a physical property of the light, that is passed through the electro-optical light transmitting elements (2a, 2b), which change is induced by the electro-optical light transmitting elements (2a, 2b).

8. The method of claims 6 and 7, wherein the electric field-dependent change is a function of the temperature of the electro-optical light transmitting element (2, 2a, 2b) and the derived temperature of the phase shifting element (3) is used in deriving the voltage (V).

9. The method of any of the preceding claims, wherein in a first time interval [t1; t2] between a first time t1 and a second time t2>t1 a range of the voltages (V) over the terminals (1a, 1b) is large enough for the signals ($S_n$) to reach their maximum and minimum values as functions of the voltages (V) and
wherein in a second time interval [t3; t4] between a third time t3>t2 and a fourth time t4>t3 the range of the voltages (V) is not large enough for the signals ($S_n$) to reach their maximum and minimum values as functions of the voltages (V) and
wherein at least a scale and/or an offset of the signals ($S_n$) that was or were derived in the first time interval [t1; t2] is or are used in deriving the voltage (V) in the second time interval [t3; t4].

10. The method of any of the preceding claims, wherein the electro-optical light transmitting element (2, 2a, 2b) comprises an optical sensor (21) introducing a field-dependent phase shift between a first polarization or mode and a second polarization or mode of light passing through the electro-optical light transmitting element (2, 2a, 2b), and in particular wherein the optical sensor (21) comprises
an electro-optical device with field-dependent birefringence, in particular a crystal, in particular of crystalline $Bi_4Ge_3O_{12}$ (BGO) or $Bi_4Si_3O_{12}$ (BSO),
or a poled waveguide exhibiting a Pockels effect,
or a piezo-electric device, in particular of crystalline quartz or a piezoelectric ceramic, and a waveguide carrying at least two modes, wherein the waveguide is connected to the piezo-electric device thus that a length of the waveguide is field-dependent.

11. The method of claim 4, wherein the phase shifting element (3) is a $\lambda/4$ retarder, and during the derivation the ambiguity is removed additionally to using a quadrature signal by using light of two different wavelengths.

12. The method of any of the preceding claims, wherein the signals ($S_n$, $S_n'$), in particular the base signal ($S_n$) and/or the reference signal ($S_n'$), is or are normalized to a symmetric value range around zero, in particular is or are scaled and offset to a value range [+1, -1].

13. The method of claim 12, wherein a bidirectional cumulative count k of the number of zero crossings is determined for the base signal ($S_n$) and is used in the deriving of the voltage (V, $V_n$).

14. The method of any of the preceding claims, wherein the deriving of the voltage (V, $V_n$) comprises reconstructing an improved waveform (V, $V_n$) of the voltage (V, $V_n$) with the steps of:

determining first voltage values ($V_1$, $V_{1n}$) of the voltage (V, $V_n$) from the base signal ($S_n$), in particular by calculating an arccosine,
determining second voltage values ($V_2$, $V_{2n}$) of the voltage (V, $V_n$) from the reference signal ($S_n'$), in particular by calculating an arccosine, and
determining the improved voltage waveform (V) from the first voltage values ($V_1$) and the second voltage values ($V_2$), the method further comprising the steps of:

for each n-th electro-optical light transmitting element (2, 2a) normalizing the base signal ($S_n$) and the reference signal ($S_n'$) to the same maximum and minimum amplitude, in particular to a value range [+1, -1], selecting a weighting parameter $\beta_n$ with $0 =< \beta_n =< 1$, and
determining the improved voltage waveform (V, $V_n$) by calculating a weighted sum $V = \sum V_n = \sum \{\beta_n * V_{1n} + (1-\beta_n) * V_{2n}\}$, with $V_{1n}$, $V_{2n}$ = first and second voltage values of the n-th electro-optical light transmitting element (2), wherein the index n is an integer that runs from n=1, 2, 3,.

15. The method of claim 14, comprising the steps of:

selecting the weighting parameter $\beta_n$ such that the more linear of the base signal ($S_n$) and the reference signal ($S_n'$) as a function of the voltage ($V$, $V_n$) is given a bigger weight, in particular that signal which is smaller in magnitude and thus closer to the linear region of the cosine function is used to reconstruct the voltage and the parameter $\beta_n$ is chosen to be either 0 or 1, depending on which signal has the smaller magnitude.

16. The method of any of the claims 14-15, comprising the steps of:
selecting the weighting parameter $\beta_n$ as a continuous function of the voltage ($V$, $V_n$), in particular according to $\beta_n = \cos^2(S_n \cdot \pi/2)/(\cos^2(S_n \cdot \pi/2)+\sin^2(S_n' \cdot \pi/2))$.

17. The method of any of the claims 1-13, wherein the first electro-optical light transmitting element (2a) is operated without a retarder.

18. The method of any of the preceding claims, wherein the hypotheses ($h^+$, $h^-$) corresponds to different possible voltage values ($V_1^{h-}$, $V_1^{h+}$) of the partial voltage ($V_n$) applied to the first electro-optical light transmitting element (2a).

19. The method of any of the preceding claims,
measuring the first signal ($S_n$) for each n-th electro-optical light transmitting element (2, 2a, 2b) and using it as the n-th base signal ($S_n$) indicative of the electric field over that n-th electro-optical light transmitting element (2a),
determining the second signal ($S_n'$) for each n-th electro-optical light transmitting element (2, 2a, 2b) and using it as the n-th reference signal ($S_n'$) for resolving the ambiguity in the deriving of the n-th partial voltage ($V_n$) over that n-th electro-optical light transmitting element (2, 2a, 2b),
wherein the n-th base signal ($S_n$) and the n-th reference signal ($S_n'$) are generated from different electro-optical light transmitting elements (2a, 2b), and index n designates the numbering of the electro-optical light transmitting elements (2, 2a, 2b) and is an integer that runs from n=1, 2, 3, ..., and
for each n-th electro-optical light transmitting element (2, 2a, 2b) performing the method steps (iii), (iv), (v) and (vi) to disambiguate the partial voltage ($V_n$) over that n-th electro-optical light transmitting element (2, 2a, 2b), and determining the full voltage ($V$) between the first (1a) and second terminal (1b) from the partial voltages ($V_n$).

20. The method of any of the preceding claims, wherein the electro-optical light transmitting elements (2a, 2b) are optically read out in parallel.

21. The method of claim 19, comprising:

applying to each electro-optical light transmitting element (2a, 2b) a partial voltage ($Vn$),
determining from the first and second signals ($Sn$, $S_n'$) the partial voltage ($Vn$) for each electro-optical light transmitting element (2a, 2b), and
determining the total voltage ($V$) between the first terminal (1a) and the second terminal (1b) by calculating the sum ($V=\sum V_n$) of all partial voltages ($V_n$).

22. The method of any of the preceding claims, further comprising the steps of:

defining at least one internal parameter $\alpha_n=V_n/V$, wherein $V_n$ = partial voltage applied to the nth electro-optic light transmitting element (2a, 2b) and $V$ = total voltage between the first terminal (1a) and the second terminal (1b),
determining an estimate of $\alpha_n$ for all electro-optical light transmitting elements (2a, 2b), and
using the $\alpha_n$ for resolving the ambiguity in the deriving of the voltage ($V$, $V_n$) from the first signal ($S_n$).

23. The method of claim 22 when not depending on claim 7, further comprising the steps of:

the voltage being in the high-voltage range and/or the voltage being an AC-voltage,
with the first signal ($S_n$) and the second signal ($S_n'$) being based on an electric field-dependent change of a physical property of the light, that is passed through the electro-optical light transmitting elements (2a, 2b), which change is induced by the electro-optical light transmitting elements (2a, 2b),
measuring electrical signals $S_n$ as a function of the intensities of the light exiting each electro-optical light transmitting element (2a, 2b),
determining all partial voltages $V_n$ according to

$$V_n = \frac{V_{h,n}}{\pi}\left(\left(\pm\arccos\left(\frac{2(S_n - b_n)}{G_n \cdot I_{n,0}} - 1\right) + K \cdot 2\pi\right) - 2\pi\Delta_n\right)$$

with $V_{h,n}$ = half-wave voltage of a crystal (21) in the nth electro-optic light transmitting element (2a, 2b), $b_n$ = signal offset, $G_n$ = cumulated gain of all components in a measurement chain from a photodiode to an amplifier, $I_{n,0}$ = intensity of the light exiting with zero retardation, K = count of periods of a cosinusoidal response, and $\Delta_n$ = relative phase of the signal with respect to the voltage (V, $V_n$) for any channel n, and

using the $\alpha_n$, in particular an estimate of the $\alpha_n$ for all optical channels, for disambiguating the sign of the arccosine.

24. The method of any of the claims 22-23, wherein the step of taking a binary decision to disambiguate the first signal ($S_n$) of the first electro-optical element (2a) with applied partial voltage ($V_1$) comprises using the $\alpha_n$ to compute from the at least two hypotheses ($V_1^{h+}$, $V_1^{h-}$) the corresponding voltage hypotheses ($V_2^{h+}$, $V_2^{h-}$) for the second electro-optical element (2b) with applied partial voltage ($V_2$), and selecting that expected value ($S_2^{h+}$, $S_2^{h-}$) of the second signal ($S_2$) which is closer to the measured value of the second signal ($S_2$).

25. The method of any of the claims 22-24, wherein strongly erroneous $\alpha_n$ are detected from an incorrect hypothesis selection, in particular from a discontinuity in the measured voltage (V), and the most common values of $\alpha_n$ which are used most of the time are determined to be the correct $\alpha_n$.

26. The method of any of the preceding claims 22-25, further comprising the step of recursively deriving at least one of the internal parameters ($\alpha_n$) by:

   initializing an auxiliary control loop with the estimate of $\alpha_n$ for all optical channels, wherein the internal parameter ($\alpha_n$) is descriptive of a distribution of the voltage (V) over the electro-optical light transmitting elements (2a, 2b), taking a first series of measurements, and
   based on the resulting $V_n$, calculating more exact $\alpha_n$ using equation $\alpha_n = V_n/V$ and the most common values of $\alpha_n$.

27. The method of claim 26, further comprising the steps of:

   using the more exact $\alpha_n$ as new estimated of $\alpha_n$, and
   converging the $\alpha_n$, and/or tracking a time dependence $\alpha_n(t)$ of the $\alpha_n$.

28. The method of any of the preceding claims, for each n-th electro-optic light transmitting element (2a, 2b) and its corresponding base signal ($S_n$) and/or reference signal ($S_n'$) performing the steps of:

   reconstructing a waveform of the measured voltage (V, $V_n$), in particular the full voltage (V) and/or partial voltage ($V_n$) between the first terminal (1a) and the second terminal (1b),
   calculating a time average over a number of periods of the reconstructed waveform,
   determining from the time average an apparent DC offset voltage $V_{DC}$, and
   calculating a relative phase $\Delta_n$ of the base signal ($S_n$) and/or reference signal ($S_n'$) with respect to the applied voltage according to $\Delta_n = V_{DC} * \pi/V_{h,n}$, with $V_{h,n}$ = half-wave voltage of the nth electro-optic light transmitting element (2a, 2b).

29. Method for measuring a voltage (V, $V_n$) according to any of the preceding claims, **characterized by** the steps of:

   (i) using the first signal ($S_n$) as a base signal ($S_n$) indicative of the electric field over the first electro-optical light transmitting element (2a),
   (ii) using the second signal ($S_n'$) as a reference signal ($S_n'$) for resolving the ambiguity in the deriving of the voltage (V, $V_n$),
   (iii) determining from the first signal ($S_n$) two hypotheses ($h^+$, $h^-$) corresponding to different possible voltage values ($V_n^{h+}$, $V_n^{h-}$) of the voltage (V, $V_n$),
   (iv) determining the actual relative phase shift $\Delta$ between the base signal $S_n$ and the reference signal $S_n'$,
   (v) determining from the base signal $S_n$, the reference signal $S_n'$ and the actual relative phase shift $\Delta$ a synthetic quadrature signal $S_n'^{quad}$ having an ideal relative phase shift of 90° by calculating $S_n'^{quad}$ according to the formula

$$S_n\text{'}^{quad} = \cos^{-1}(2*\pi*\Delta) \; * \; S_n\text{'} + \tan(2*\pi*\Delta) \; * \; S_n \; , \; and$$

and

(vi) taking a binary decision between the hypotheses (h+, h-) based on the sign of the synthetic quadrature signal $S_n\text{'}^{quad}$.

30. A device for measuring the voltage (V) comprising means that carry out the steps of the method according to any of the preceding claims.

**Patentansprüche**

1. Ein Verfahren zum Messen einer Spannung (V, $V_n$), insbesondere einer Vollspannung (V) und/oder Teilspannung ($V_n$), zwischen einem ersten Anschluss (1a) und einem zweiten Anschluss (1b), wobei der erste Anschluss (1a) von dem zweiten Anschluss (1b) räumlich getrennt ist, und wobei die Spannung (V, $V_n$) ein elektrisches Feld zwischen den Anschlüssen (1a, 1b) erzeugt, das Verfahren umfassend die Schritte

    Anordnen mindestens eines ersten elektrooptischen lichtdurchlässigen Elements (2, 2a) in dem elektrischen Feld zwischen dem ersten (1a) und dem zweiten Anschluss (1b),

    Hindurchleiten von Licht durch das erste elektrooptische lichtdurchlässige Element (2, 2a),

    Messen mindestens eines ersten Signals ($S_n$) von dem ersten elektrooptischen lichtdurchlässigen Element (2, 2a) und ferner Messen eines zweiten Signals ($S_n$') von einem zweiten elektrooptischen lichtdurchlässigen Element (2, 2a, 2b, 2c), wobei beide Signale ($S_n$, $S_n$') periodische Funktionen der Spannung (V) sind und eine relative Phasenverschiebung ungleich null aufweisen,

    Ableiten der Spannung (V, $V_n$) und Auflösen einer Mehrdeutigkeit beim Ableiten der Spannung (V, $V_n$) aus dem ersten ($S_n$) und dem zweiten Signal ($S_n$'), **gekennzeichnet durch** die Schritte:

    (i) Verwenden des ersten Signals ($S_n$) als ein Basissignal ($S_n$), das das elektrische Feld über dem ersten elektrooptischen lichtdurchlässigen Element (2, 2a) anzeigt,

    (ii) Verwenden des zweiten Signals ($S_n$') als ein Referenzsignal ($S_n$') zum Auflösen der Mehrdeutigkeit beim Ableiten der Spannung (V, $V_n$),

    (iii) Bestimmen, aus dem ersten Signal ($S_n$), von mindestens zwei Hypothesen (h+, h-), die unterschiedlichen möglichen Spannungswerten ($V_n^{h+}$, $V_n^{h-}$) der Spannung (V, $V_n$) entsprechen,

    (iv) Ableiten eines Erwartungswerts ($S_n^{h+}$, $S_n^{h-}$) des zweiten Signals ($S_n$') für jede der Hypothesen (h+, h-) ,

    (v) Vergleichen der Erwartungswerte ($S_n^{h+}$, $S_n^{h-}$) mit einem Messwert des zweiten Signals ($S_2$), und

    (vi) Treffen einer binären Entscheidung zwischen den Hypothesen (h+, h-) durch Validieren jener Hypothese (h+, h-), für die der Erwartungswert ($S_n^{h+}$, $S_n^{h-}$) dem Messwert des zweiten Signals ($S_n$') am nächsten ist,

    wobei eine Wellenform der angelegten Spannung (V) zwischen dem ersten Anschluss (1a) und dem zweiten Anschluss (1b) unter Verwendung von mehreren elektrooptischen lichtdurchlässigen Elementen (2a, 2b) rekonstruiert wird, ohne dass ein Quadratursignal für jedes elektrooptische lichtdurchlässige Element (2a, 2b) erforderlich ist, wobei die elektrooptischen lichtdurchlässigen Elemente (2a, 2b) in einer axialen Richtung zwischen den Anschlüssen (1a, 1b) in Reihe angeordnet sind, und wobei ferner nur ein Signal ($S_n$) pro elektrooptischem lichtdurchlässigen Element (2, 2a, 2b) gemessen wird.

2. Das Verfahren nach Anspruch 1, wobei genau zwei Hypothesen (h+, h-) bestimmt werden und genau ein Referenzsignal ($S_n$') pro Basissignal ($S_n$) verwendet wird, und/oder wobei eine Nähe der Erwartungswerte ($S_n^{h+}$, $S_n^{h-}$) zu dem Messwert ($S_n$') unter Verwendung von euklidischem Abstand bestimmt wird.

3. Das Verfahren nach einem der vorhergehenden Ansprüche, wobei das erste Signal ($S_n$) und das zweite Signal ($S_n$') die gleiche Periodizität der Spannung (V) aufweisen.

4. Das Verfahren nach einem der vorhergehenden Ansprüche, wobei die relative Phasenverschiebung zwischen dem ersten Signal ($S_n$) und dem zweiten Signal ($S_n$') durch ein Phasenverschiebungselement (3) eingebracht wird, das in einem Strahlengang in dem zweiten elektrooptischen lichtdurchlässigen Element (2b) angeordnet ist, wobei das Phasenverschiebungselement (3) insbesondere ein λ/4-Plättchen ist.

5. Das Verfahren nach einem der vorhergehenden Ansprüche, wobei die relative Phasenverschiebung zwischen dem

ersten Signal ($S_n$) und dem zweiten Signal ($S_n$') ungleich 90° ist.

6.  Das Verfahren nach Anspruch 5, wobei die relative Phasenverschiebung zwischen dem ersten Signal ($S_n$) und dem zweiten Signal ($S_n$') eine Funktion der Temperatur des Phasenverschiebungselements (3) ist und die Temperatur des Phasenverschiebungselements (3) aus dem zweiten Signal ($S_n$') abgeleitet wird.

7.  Das Verfahren nach einem der vorhergehenden Ansprüche, wobei insbesondere die Spannung im Hochspannungsbereich liegt und/oder die Spannung eine Wechselspannung ist, wobei das erste Signal ($S_n$) und das zweite Signal ($S_n$') auf einer von einem elektrischen Feld abhängigen Veränderung einer physikalischen Eigenschaft des Lichts, das durch die elektrooptischen lichtdurchlässigen Elemente (2a, 2b) hindurchgeleitet wird, basieren, wobei die Veränderung durch die elektrooptischen lichtdurchlässigen Elemente (2a, 2b) veranlasst wird.

8.  Das Verfahren nach Anspruch 6 und 7, wobei die von einem elektrischen Feld abhängige Veränderung eine Funktion der Temperatur des elektrooptischen lichtdurchlässigen Elements (2, 2a, 2b) ist und die abgeleitete Temperatur des Phasenverschiebungselements (3) beim Ableiten der Spannung (V) verwendet wird.

9.  Das Verfahren nach einem der vorhergehenden Ansprüche, wobei ein Bereich der Spannungen (V) über den Anschlüssen (1a, 1b) in einem ersten Zeitintervall [t1; t2] zwischen einer ersten Zeit t1 und einer zweiten Zeit t2 > t1 groß genug dafür ist, dass die Signale ($S_n$) ihre Maximal- und Minimalwerte als Funktionen der Spannungen (V) erreichen, und
    wobei der Bereich der Spannungen (V) in einem zweiten Zeitintervall [t3; t4] zwischen einer dritten Zeit t3 > t2 und einer vierten Zeit t4 > t3 nicht groß genug dafür ist, dass die Signale ($S_n$) ihre Maximal- und Minimalwerte als Funktionen der Spannungen (V) erreichen, und
    wobei mindestens eine Skalierung und/oder ein Versatz der Signale ($S_n$), die oder der in dem ersten Zeitintervall [t1; t2] abgeleitet wurde oder wurden, beim Ableiten der Spannung (V) in dem zweiten Zeitintervall [t3; t4] verwendet wird oder werden.

10. Das Verfahren nach einem der vorhergehenden Ansprüche, wobei das elektrooptische lichtdurchlässige Element (2, 2a, 2b) einen optischen Sensor (21) umfasst, der eine feldabhängige Phasenverschiebung zwischen einer ersten Polarisation oder Mode und einer zweiten Polarisation oder Mode von Licht, das sich durch das elektrooptische lichtdurchlässige Element (2, 2a, 2b) hindurchbewegt, einbringt, und wobei der optische Sensor (21) insbesondere aufweist
    eine elektrooptische Vorrichtung mit feldabhängiger Doppelbrechung, insbesondere einen Kristall, insbesondere aus kristallinem $Bi_4Ge_3O_{12}$ (BGO) oder $Bi_4Si_3O_{12}$ (BSO),
    oder einen gepolten Wellenleiter, der einen Pockels-Effekt aufweist,
    oder eine piezoelektrische Vorrichtung, insbesondere aus kristallinem Quarz oder einer piezoelektrischen Keramik, und einen Wellenleiter, der mindestens zwei Moden trägt, wobei der Wellenleiter derart mit der piezoelektrischen Vorrichtung verbunden ist, dass eine Länge des Wellenleiters feldabhängig ist.

11. Das Verfahren nach Anspruch 4, wobei das Phasenverschiebungselement (3) ein $\lambda/4$-Plättchen ist und wobei die Mehrdeutigkeit während der Ableitung zusätzlich zur Verwendung eines Quadratursignals unter Verwendung von Licht mit zwei unterschiedlichen Wellenlängen entfernt wird.

12. Das Verfahren nach einem der vorhergehenden Ansprüche, wobei die Signale ($S_n$, $S_n$'), insbesondere das Basis-signal ($S_n$) und/oder das Referenzsignal ($S_n$'), auf einen symmetrischen Wertebereich um null normalisiert wird oder werden, insbesondere auf einen Wertebereich [+1, -1] skaliert und versetzt wird oder werden.

13. Das Verfahren nach Anspruch 12, wobei eine bidirektionale kumulative Zählung k der Anzahl von Nulldurchgängen für das Basissignal ($S_n$) bestimmt wird und beim Ableiten der Spannung (V, $V_n$) verwendet wird.

14. Das Verfahren nach einem der vorhergehenden Ansprüche, wobei das Ableiten der Spannung (V, $V_n$) ein Rekon-struieren einer verbesserten Wellenform (V, $V_n$) der Spannung (V, $V_n$) mit folgenden Schritten umfasst:

    Bestimmen erster Spannungswerte ($V_1$, $V_{1n}$) der Spannung (V, $V_n$) aus dem Basissignal ($S_n$), insbesondere durch Berechnen eines Arcuscosinus,
    Bestimmen zweiter Spannungswerte ($V_2$, $V_{2n}$) der Spannung (V, $V_n$) aus dem Referenzsignal ($S_n$'), insbeson-dere durch Berechnen eines Arcuscosinus, und
    Bestimmen der verbesserten Spannungswellenform (V) aus den ersten Spannungswerten ($V_1$) und den zweiten

EP 2 715 375 B1

Spannungswerten ($V_2$), das Verfahren ferner umfassend die Schritte:

> Normalisieren, für jedes n-te elektrooptische lichtdurchlässige Element (2, 2a), des Basissignals ($S_n$) und des Referenzsignals ($S_n$') auf dieselbe maximale und minimale Amplitude, insbesondere auf einen Wertebereich [+1, -1],
> Auswählen eines Gewichtungsparameters $\beta_n$ mit $0 = <\beta_n = <1$, und
> Bestimmen der verbesserten Spannungswellenform (V, $V_n$) durch Berechnen einer gewichteten Summe $V = \sum V_n = \sum\{\beta_n*V_{1n} + (1-\beta_n)*V_{2n}\}$, wobei $V_{1n}$, $V_{2n}$ = erste und zweite Spannungswerte des n-ten elektrooptischen lichtdurchlässigen Elements (2), wobei der Index n eine ganze Zahl ist, die von n = 1, 2, 3, verläuft.

15. Das Verfahren nach Anspruch 14, umfassend die Schritte:
Auswählen des Gewichtungsparameters $\beta_n$ derart, dass das linearere von dem Basissignal ($S_n$) und dem Referenzsignal ($S_n$') als eine Funktion der Spannung (V, $V_n$) stärker gewichtet wird, wobei insbesondere das Signal, das hinsichtlich der Stärke kleiner und damit näher am linearen Bereich der Cosinusfunktion ist, verwendet wird, um die Spannung zu rekonstruieren, und der Parameter $\beta_n$ so ausgewählt wird, dass er abhängig davon, welches Signal die geringere Stärke aufweist, entweder 0 oder 1 ist.

16. Das Verfahren nach einem der Ansprüche 14-15, umfassend die Schritte:
Auswählen eines Gewichtungsparameters $\beta_n$ als kontinuierliche Funktion der Spannung (V, $V_n$), insbesondere gemäß $\beta_n = \cos^2(S_n*\pi/2) / (\cos^2(S_n*\pi/2) + \sin^2(S_n'*\pi/2))$.

17. Das Verfahren nach einem der Ansprüche 1-13, wobei das erste elektrooptische lichtdurchlässige Element (2a) ohne eine Verzögerungsplatte betrieben wird.

18. Das Verfahren nach einem der vorhergehenden Ansprüche, wobei die Hypothesen ($h^+$, $h^-$) unterschiedlichen möglichen Spannungswerten ($V_1^{h-}$, $V_1^{h+}$) der Teilspannung ($V_n$), die an dem ersten elektrooptischen lichtdurchlässigen Element (2a) angelegt ist, entsprechen.

19. Das Verfahren nach einem der vorhergehenden Ansprüche,
Messen des ersten Signals ($S_n$) für jedes n-te elektrooptische lichtdurchlässige Element (2, 2a, 2b) und Verwenden davon als das n-te Basissignal ($S_n$), das das elektrische Feld über diesem n-ten elektrooptischen lichtdurchlässigen Element (2a) anzeigt,
Bestimmen des zweiten Signals ($S_n$') für jedes n-te elektrooptische lichtdurchlässige Element (2, 2a, 2b) und Verwenden davon als das n-te Referenzsignal ($S_n$') zum Auflösen der Mehrdeutigkeit beim Ableiten der n-ten Teilspannung ($V_n$) über diesem n-ten elektrooptischen lichtdurchlässigen Element (2, 2a, 2b),
wobei das n-te Basissignal ($S_n$) und das n-te Referenzsignal ($S_n$') von unterschiedlichen elektrooptischen lichtdurchlässigen Elementen (2a, 2b) aus erzeugt werden und Index n die Anzahl der elektrooptischen lichtdurchlässigen Elemente (2, 2a, 2b) angibt und eine ganze Zahl ist, die von n = 1, 2, 3, ... verläuft, und
Durchführen, für jedes n-te elektrooptische lichtdurchlässige Element (2, 2a, 2b), der Verfahrensschritte (iii), (iv), (v) und (vi), um die Teilspannung ($V_n$) über dem n-ten elektrooptischen lichtdurchlässigen Element (2, 2a, 2b) zu vereindeutigen, und
Bestimmen der Vollspannung (V) zwischen dem ersten (1a) und zweiten Anschluss (1b) aus den Teilspannungen ($V_n$).

20. Das Verfahren nach einem der vorhergehenden Ansprüche, wobei die elektrooptischen lichtdurchlässigen Elemente (2a, 2b) optisch parallel ausgelesen werden.

21. Das Verfahren nach Anspruch 19, umfassend:

> Anlegen, an jedem elektrooptischen lichtdurchlässigen Element (2a, 2b) einer Teilspannung ($V_n$),
> Bestimmen, aus den ersten und zweiten Signalen ($S_n$, $S_n$'), der Teilspannung ($V_n$) für jedes elektrooptische lichtdurchlässige Element (2a, 2b), und
> Bestimmen der Vollspannung (V) zwischen dem ersten Anschluss (1a) und dem zweiten Anschluss (1b) durch Berechnen der Summe ($V = \sum V_n$) aller Teilspannungen ($V_n$).

22. Das Verfahren nach einem der vorhergehenden Ansprüche, ferner umfassend die Schritte:

> Definieren von mindestens einem internen Parameter $\alpha_n = V_n/V$, wobei $V_n$ = Teilspannung, die an dem n-ten elektrooptischen lichtdurchlässigen Element (2a, 2b) angelegt ist, und V = Vollspannung zwischen dem ersten Anschluss (1a) und dem zweiten Anschluss (1b),

Bestimmen einer Schätzung von $\alpha_n$ für alle elektrooptischen lichtdurchlässigen Elemente (2a, 2b), und

Verwenden des $\alpha_n$ zum Auflösen der Mehrdeutigkeit beim Ableiten der Spannung (V, $V_n$) aus dem ersten Signal ($S_n$).

23. Das Verfahren nach Anspruch 22, wenn nicht von Anspruch 7 abhängig, ferner umfassend die Schritte:

wenn die Spannung im Hochspannungsbereich liegt und/oder die Spannung eine Wechselspannung ist,

wobei das erste Signal ($S_n$) und das zweite Signal ($S_n$') auf einer von einem elektrischen Feld abhängigen Veränderung einer physikalischen Eigenschaft des Lichts, das durch die elektrooptischen lichtdurchlässigen Elemente (2a, 2b) hindurchgeleitet wird, basieren, wobei die Veränderung durch die elektrooptischen lichtdurchlässigen Elemente (2a, 2b) veranlasst wird,

Messen elektrischer Signale $S_n$ als eine Funktion der Intensitäten des Lichts, das aus jedem elektrooptischen lichtdurchlässigen Element (2a, 2b) austritt,

Bestimmen aller Teilspannungen $V_n$ gemäß

$$V_n = \frac{V_{h,n}}{\pi}\left(\left(\pm\arccos\left(\frac{2(S_n - b_n)}{G_n \cdot I_{n,0}} - 1\right) + K \cdot 2\pi\right) - 2\pi\Delta_n\right)$$

wobei $V_{h,n}$ = Halbwellenspannung eines Kristalls (21) in dem n-ten elektrooptischen lichtdurchlässigen Element (2a, 2b), $b_n$ = Signalversatz, $G_n$ = kumulierte Verstärkung aller Komponenten in einer Messkette von einer Photodiode zu einem Verstärker, $I_{n,0}$ = Intensität des mit Nullverzögerung austretenden Lichts, K = Zählung von Perioden einer cosinusförmigen Antwort und $\Delta_n$ = relative Phase des Signals in Bezug auf die Spannung (V, $V_n$) für einen beliebigen Kanal n, und

Verwenden des $\alpha_n$, insbesondere einer Schätzung des $\alpha_n$ für alle optischen Kanäle, zum Vereindeutigen des Vorzeichens des Arcuscosinus.

24. Das Verfahren nach einem der Ansprüche 22-23, wobei der Schritt des Treffens einer binären Entscheidung, um das erste Signal ($S_n$) des elektrooptischen Elements (2a) mit angelegter Teilspannung ($V_1$) zu vereindeutigen, eine Verwendung des $\alpha_n$ zum Berechnen, aus den mindestens zwei Hypothesen ($V_1^{h+}$, $V_1^{h-}$), der entsprechenden Spannungshypothesen ($V_2^{h+}$, $V_2^{h-}$) für das zweite elektrooptische Element (2b) mit angelegter Teilspannung ($V_2$) und Auswählen des Erwartungswerts ($S_2^{h+}$, $S_2^{h-}$) des zweiten Signals (S2), der näher an dem Messwert des zweiten Signals ($S_2$) ist, umfasst.

25. Das Verfahren nach einem der Ansprüche 22-24, wobei stark fehlerhafte $\alpha_n$ aus einer falschen Hypothesenauswahl, insbesondere aus einer Diskontinuität der gemessenen Spannung (V), erkannt werden und die häufigsten Werte von $\alpha_n$, die am häufigsten verwendet werden, als das korrekte $\alpha_n$ bestimmt werden.

26. Das Verfahren nach einem der vorhergehenden Ansprüche 22-25, ferner umfassend den Schritt des rekursiven Ableitens von mindestens einem der internen Parameter ($\alpha_n$) durch:

Initialisieren eines Hilfsregelkreises mit der Schätzung von $\alpha_n$ für alle optischen Kanäle, wobei der interne Parameter ($\alpha_n$) eine Verteilung der Spannung (V) über den elektrooptischen lichtdurchlässigen Elementen (2a, 2b) beschreibt,

Vornehmen einer ersten Reihe von Messungen, und

Berechnen, basierend auf dem resultierenden $V_n$, eines genaueren $\alpha_n$ unter Verwendung der Gleichung $\alpha_n = V_n/V$ und der häufigsten Werte von $\alpha_n$.

27. Das Verfahren nach Anspruch 26, ferner umfassend die Schritte:

Verwenden des genaueren $\alpha_n$ als neue geschätzte von $\alpha_n$ und Konvergieren des $\alpha_n$ und/oder Verfolgen einer Zeitabhängigkeit $\alpha_n(t)$ des $\alpha_n$.

28. Das Verfahren nach einem der vorhergehenden Ansprüche, wobei für jedes n-te elektrooptische lichtdurchlässige Element (2a, 2b) und dessen entsprechendes Basissignal ($S_n$) und/oder Referenzsignal ($S_n$') folgende Schritte durchgeführt werden:

Rekonstruieren einer Wellenform der gemessenen Spannung (V, $V_n$), insbesondere der Vollspannung (V) und/oder Teilspannung ($V_n$), zwischen dem ersten Anschluss (1a) und dem zweiten Anschluss (1b),

Berechnen eines Zeitmittelwerts über eine Anzahl von Perioden der rekonstruierten Wellenform hinweg,

Bestimmen, aus dem Zeitmittelwert, einer scheinbaren Offset-Gleichspannung $V_{DC}$, und

Berechnen einer relativen Phase $\Delta_n$ des Basissignals ($S_n$) und/oder Referenzsignals ($S_n'$) in Bezug auf die angelegte Spannung gemäß $\Delta_n = V_{DC}*\pi/V_{h,n}$, wobei $V_{h,n}$ = Halbwellenspannung des n-ten elektrooptischen lichtdurchlässigen Elements (2a, 2b).

29. Verfahren zum Messen einer Spannung (V, $V_n$) nach einem der vorhergehenden Ansprüche, **gekennzeichnet durch** die Schritte:

(i) Verwenden des ersten Signals ($S_n$) als ein Basissignal ($S_n$), das das elektrische Feld über dem ersten elektrooptischen lichtdurchlässigen Element (2a) anzeigt,

(ii) Verwenden des zweiten Signals ($S_n'$) als ein Referenzsignal ($S_n'$) zum Auflösen der Mehrdeutigkeit beim Ableiten der Spannung (V, $V_n$),

(iii) Bestimmen, aus dem ersten Signal ($S_n$), von zwei Hypothesen ($h^+$, $h^-$), die unterschiedlichen möglichen Spannungswerten ($V_n^{h+}$, $V_n^{h-}$) der Spannung (V, $V_n$) entsprechen,

(iv) Bestimmen der tatsächlichen relativen Phasenverschiebung $\Delta$ zwischen dem Basissignal $S_n$ und dem Referenzsignal $S_n'$,

(v) Bestimmen, aus dem Basissignal $S_n$, dem Referenzsignal $S_n'$ und der tatsächlichen relativen Phasenverschiebung $\Delta$, eines synthetischen Quadratursignals $S_n'^{quad}$, das eine ideale relative Phasenverschiebung von 90° aufweist, durch Berechnen von $S_n'^{quad}$ gemäß der Formel $S_n'^{quad} = \cos^{-1}(2*\pi*\Delta) * S_n' + \tan(2*\pi*\Delta) * S_n$, und

(vi) Treffen einer binären Entscheidung zwischen den Hypothesen ($h^+$, $h^-$) basierend auf dem Vorzeichen des synthetischen Quadratursignals $S_n'^{quad}$.

30. Eine Vorrichtung zum Messen der Spannung (V), die Mittel aufweist, welche die Schritte des Verfahrens nach einem der vorhergehenden Ansprüche durchführen.

## Revendications

1. Procédé de mesure d'une tension (V, $V_n$), plus particulièrement d'une pleine tension (V) ou d'une tension partielle ($V_n$) entre une première borne (1a) et une deuxième borne (1b), la première borne (1a) étant spatialement séparée de la deuxième borne (1b) et la tension (V, $V_n$) créant un champ électrique entre les bornes (1a, 1b), le procédé comprenant les étapes suivantes :

agencement d'au moins un premier élément de transmission de lumière électro-optique (2, 2a) dans le champ électrique entre la première (1a) et la deuxième borne (1b),

passage de lumière au travers du premier élément de transmission de lumière électro-optique (2, 2a),

mesure d'au moins un premier signal ($S_n$) issu du premier élément de transmission de lumière électro-optique (2, 2a) et mesure en outre d'un deuxième signal ($S_n'$) issu d'un deuxième élément de transmission de lumière électro-optique (2, 2a, 2b, 2c), les signaux ($S_n$, $S_n'$) étant tous deux des fonctions périodiques de la tension (V) et possédant un déphasage relatif différent de zéro,

déduction de la tension (V, $V_n$) et résolution d'une ambiguïté lors de la déduction de la tension (V, $V_n$) à partir du premier ($S_n$) et du deuxième signal ($S_n'$), le procédé étant **caractérisé par** les étapes suivantes :

(i) utilisation du premier signal ($S_n$) comme un signal de base ($S_n$) indiquant le champ électrique sur le premier élément de transmission de lumière électro-optique (2, 2a),

(ii) utilisation du deuxième signal ($S_n'$) comme un signal de référence ($S_n'$) pour la résolution de l'ambiguïté lors de la déduction de la tension (V, $V_n$),

(iii) détermination, à partir du premier signal ($S_n$), d'au moins deux hypothèses ($h^+$, $h^-$) correspondant à différentes valeurs de tension possibles ($V_n^{h+}$, $V_n^{h-}$) de la tension (V, $V_n$),

(iv) déduction d'une valeur attendue ($S_n^{h+}$, $S_n^{h-}$) du deuxième signal ($S_n'$) pour chacune des hypothèses ($h^+$, $h^-$),

(v) comparaison des valeurs attendues ($S_n^{h+}$, $S_n^{h-}$) à une valeur mesurée du deuxième signal ($S_2$), et

(vi) prise d'une décision binaire entre les hypothèses ($h^+$, $h^-$) par validation de l'hypothèse ($h^+$, $h^-$) pour laquelle la valeur attendue ($S_n^{h+}$, $S_n^{h-}$) est la plus proche de la valeur mesurée du deuxième signal ($S_n'$),

une forme d'onde de la tension appliquée (V) entre la première borne (1a) et la deuxième borne (1b) étant reconstituée à l'aide d'une pluralité d'éléments de transmission de lumière électro-optiques (2a, 2b) sans recours à un signal en quadrature pour chaque élément de transmission de lumière électro-optique (2a, 2b),

les éléments de transmission de lumière électro-optiques (2a, 2b) étant agencés en série dans une direction axiale entre les bornes (1a, 1b), et

en outre, un seul signal ($S_n$) par élément de transmission de lumière électro-optique (2, 2a, 2b) étant mesuré.

2. Procédé selon la revendication 1, dans lequel exactement deux hypothèses ($h^+$, $h^-$) sont déterminées et exactement un signal de référence ($S_n'$) par signal de base ($S_n$) est utilisé, et/ou dans lequel la proximité des valeurs attendues ($S_n^{h+}$, $S_n^{h-}$) par rapport à la valeur mesurée ($S_n'$) est déterminée à l'aide d'une distance euclidienne.

3. Procédé selon l'une quelconque des revendications précédentes, dans lequel le premier signal ($S_n$) et le deuxième signal ($S_n'$) possèdent la même périodicité que celle de la tension (V).

4. Procédé selon l'une quelconque des revendications précédentes, dans lequel le déphasage relatif entre le premier signal ($S_n$) et le deuxième signal ($S_n'$) est introduit par un élément déphaseur (3) agencé dans un chemin optique dans le deuxième élément de transmission de lumière électro-optique (2b), l'élément déphaseur (3) étant plus particulièrement un retardateur $\lambda/4$.

5. Procédé selon l'une quelconque des revendications précédentes, dans lequel le déphasage relatif entre le premier signal ($S_n$) et le deuxième signal ($S_n'$) est différent de 90°.

6. Procédé selon la revendication 5, dans lequel le déphasage relatif entre le premier signal ($S_n$) et le deuxième signal ($S_n'$) est fonction de la température de l'élément déphaseur (3), et la température de l'élément déphaseur (3) est déduite du deuxième signal ($S_n'$).

7. Procédé selon l'une quelconque des revendications précédentes, plus particulièrement dans lequel la tension s'inscrit dans la plage des hautes tensions et/ou la tension consiste en une tension alternative, le premier signal ($S_n$) et le deuxième signal ($S_n'$) étant basés sur une modification, dépendant du champ électrique, d'une propriété physique de la lumière passant au travers des éléments de transmission de lumière électro-optiques (2a, 2b), laquelle modification est causée par les éléments de transmission de lumière électro-optiques (2a, 2b).

8. Procédé selon les revendications 6 et 7, dans lequel la modification dépendant du champ électrique est fonction de la température de l'élément de transmission de lumière électro-optique (2, 2a, 2b) et la température déduite de l'élément déphaseur (3) est utilisée lors de la déduction de la tension (V).

9. Procédé selon l'une quelconque des revendications précédentes, dans lequel, dans un premier intervalle de temps [t1 ; t2] entre un premier instant t1 et un deuxième instant t2>t1, une plage des tensions (V) sur les bornes (1a, 1b) est suffisamment large pour que les signaux ($S_n$) atteignent leurs valeurs maximales et minimales en fonction des tensions (V) et

dans lequel, dans un deuxième intervalle de temps [t3 ; t4] entre un troisième instant t3>t2 et un quatrième instant t4>t3, la plage des tensions (V) n'est pas suffisamment large pour que les signaux ($S_n$) atteignent leurs valeurs maximales et minimales en fonction des tensions (V) et

dans lequel au moins une échelle et/ou un décalage des signaux ($S_n$) ayant été déduits/déduit dans le premier intervalle de temps [t1 ; t2] sont/est utilisés/utilisé(e) lors de la déduction de la tension (V) dans le deuxième intervalle de temps [t3 ; t4].

10. Procédé selon l'une quelconque des revendications précédentes, dans lequel l'élément de transmission de lumière électro-optique (2, 2a, 2b) comprend un capteur optique (21) introduisant un déphasage, dépendant du champ, entre une première polarisation ou un premier mode et une deuxième polarisation ou un deuxième mode de la lumière passant au travers de l'élément de transmission de lumière électro-optique (2, 2a, 2b) et, plus particulièrement, dans lequel le capteur optique (21) comprend

un dispositif électro-optique à biréfringence dépendant du champ, plus particulièrement un cristal, plus particulièrement en $Bi_4Ge_3O_{12}$ (BGO) ou $Bi_4Si_3O_{12}$ (BSO) cristallin,

ou un guide d'ondes polarisé à effet de Pockels,

ou un dispositif piézoélectrique, plus particulièrement en quartz cristallin ou une céramique piézoélectrique, et un guide d'ondes véhiculant au moins deux modes, le guide d'ondes étant relié au dispositif piézoélectrique de telle sorte qu'une longueur du guide d'ondes soit dépendante du champ.

**11.** Procédé selon la revendication 4, dans lequel l'élément déphaseur (3) est un retardateur À/4 et, lors de la déduction, l'ambiguïté est éliminée, outre à l'aide d'un signal en quadrature, à l'aide de lumière à deux longueurs d'onde différentes.

**12.** Procédé selon l'une quelconque des revendications précédentes, dans lequel les signaux ($S_n$, $S_n'$), plus particulièrement le signal de base ($S_n$) et/ou le signal de référence ($S_n'$), sont/est normalisés/normalisé sur une plage de valeurs symétrique autour de zéro, plus particulièrement sont/est mis à l'échelle et décalés/décalé sur une plage de valeurs [+1, -1].

**13.** Procédé selon la revendication 12, dans lequel un compte bidirectionnel cumulé k du nombre de passages par zéro est déterminé pour le signal de base ($S_n$) et est utilisé lors de la déduction de la tension ($V$, $V_n$).

**14.** Procédé selon l'une quelconque des revendications précédentes, dans lequel la déduction de la tension ($V$, $V_n$) comprend la reconstitution d'une forme d'onde améliorée ($V$, $V_n$) de la tension ($V$, $V_n$) à l'aide des étapes suivantes :

détermination de premières valeurs de tension ($V_1$, $V_{1n}$) de la tension ($V$, $V_n$) à partir du signal de base ($S_n$), plus particulièrement par calcul d'un arc-cosinus,
détermination de deuxièmes valeurs de tension ($V_2$, $V_{2n}$) de la tension ($V$, $V_n$) à partir du signal de référence ($S_n'$), plus particulièrement par calcul d'un arc-cosinus, et
détermination de la forme d'onde de tension améliorée ($V$) à partir des premières valeurs de tension ($V_1$) et des deuxièmes valeurs de tension ($V_2$), le procédé comprenant en outre les étapes suivantes :

pour chaque n-ième élément de transmission de lumière électro-optique (2, 2a), normalisation du signal de base ($S_n$) et du signal de référence ($S_n'$) sur la même amplitude maximale et minimale, plus particulièrement sur la plage de valeurs [+1, -1],
sélection d'un paramètre de pondération $\beta_n$ avec $0=<\beta_n=<1$, et
détermination de la forme d'onde de tension améliorée ($V$, $V_n$) par calcul d'une somme pondérée $V=\Sigma V_n$ $= \Sigma\{\beta_n*V_{1n} + (1-\beta_n)*V_{2n}\}$ avec $V_{1n}$, $V_{2n}$ = première et deuxième valeurs de tension du n-ième élément de transmission de lumière électro-optique (2), l'indice n étant un entier allant de n=1, 2, 3,.

**15.** Procédé selon la revendication 14, comprenant les étapes suivantes :
sélection du paramètre de pondération $\beta_n$ de sorte que le signal le plus linéaire parmi le signal de base ($S_n$) et le signal de référence ($S_n'$) en fonction de la tension ($V$, $V_n$) reçoit un poids plus important, plus particulièrement de sorte que le signal qui est de plus faible amplitude et donc le plus proche de la région linéaire de la fonction cosinus est utilisé pour reconstituer la tension et le paramètre $\beta_n$ est choisi comme valant soit 0, soit 1, selon le signal qui a la plus faible amplitude.

**16.** Procédé selon l'une quelconque des revendications 14-15, comprenant les étapes suivantes :
sélection du paramètre de pondération $\beta_n$ comme une fonction continue de la tension ($V$, $V_n$), plus particulièrement selon $\beta_n = \cos^2(S_n*\pi/2)/(\cos^2(S_n*\pi/2)+\sin^2(S_n'*\pi/2))$.

**17.** Procédé selon l'une quelconque des revendications 1-13, dans lequel le premier élément de transmission de lumière électro-optique (2a) fonctionne sans retardateur.

**18.** Procédé selon l'une quelconque des revendications précédentes, dans lequel les hypothèses ($h^+$, $h^-$) correspondent à différentes valeurs de tension possibles ($V_1^{h+}$, $V_1^{h-}$) de la tension partielle ($V_n$) appliquée au premier élément de transmission de lumière électro-optique (2a).

**19.** Procédé selon l'une quelconque des revendications précédentes,
mesure du premier signal ($S_n$) pour chaque n-ième élément de transmission de lumière électro-optique (2, 2a, 2b) et utilisation de celui-ci comme le n-ième signal de base ($S_n$) indiquant le champ électrique sur cet n-ième élément de transmission de lumière électro-optique (2a),
détermination du deuxième signal ($S_n'$) pour chaque n-ième élément de transmission de lumière électro-optique (2, 2a, 2b) et utilisation de celui-ci comme le n-ième signal de référence ($S_n'$) pour la résolution de l'ambiguïté lors de la déduction de la n-ième tension partielle ($V_n$) sur cet n-ième élément de transmission de lumière électro-optique (2, 2a, 2b),
le n-ième signal de base ($S_n$) et le n-ième signal de référence ($S_n'$) étant générés à partir d'éléments de transmission de lumière électro-optiques différents (2a, 2b), et l'indice n désignant la numérotation des éléments de transmission de lumière électro-optiques (2, 2a, 2b) et étant un entier allant de n=1, 2, 3, ..., et

pour chaque n-ième élément de transmission de lumière électro-optique (2, 2a, 2b), mise en oeuvre des étapes de procédé (iii), (iv), (v) et (vi) dans le but de lever l'ambiguïté quant à la tension partielle ($V_n$) sur cet n-ième élément de transmission de lumière électro-optique (2, 2a, 2b), et

détermination de la pleine tension (V) entre la première (1a) et la deuxième borne (1b) à partir des tensions partielles ($V_n$).

20. Procédé selon l'une quelconque des revendications précédentes, dans lequel les éléments de transmission de lumière électro-optiques (2a, 2b) sont lus optiquement en parallèle.

21. Procédé selon la revendication 19, comprenant :

l'application, à chaque élément de transmission de lumière électro-optique (2a, 2b), d'une tension partielle ($V_n$),
la détermination, à partir des premier et deuxième signaux ($S_n$, $S_n$'), de la tension partielle ($V_n$) pour chaque élément de transmission de lumière électro-optique (2a, 2b), et
la détermination de la tension totale (V) entre la première borne (1a) et la deuxième borne (1b) par calcul de la somme ($V=\sum V_n$) de toutes les tensions partielles ($V_n$).

22. Procédé selon l'une quelconque des revendications précédentes, comprenant en outre les étapes suivantes :

définition d'au moins un paramètre interne $\alpha_n = V_n/V$, $V_n$ = tension partielle appliquée au n-ième élément de transmission de lumière électro-optique (2a, 2b) et V = tension totale entre la première borne (1a) et la deuxième borne (1b),
détermination d'une estimation de $\alpha_n$ pour tous les éléments de transmission de lumière électro-optiques (2a, 2b), et
utilisation du $\alpha_n$ pour résoudre l'ambiguïté lors de la déduction de la tension (V, $V_n$) à partir du premier signal ($S_n$).

23. Procédé selon la revendication 22 lorsqu'elle ne dépend pas de la revendication 7, comprenant en outre les étapes suivantes :

la tension s'inscrivant dans la plage des hautes tensions et/ou la tension consistant en une tension alternative,
le premier signal ($S_n$) et le deuxième signal ($S_n$') étant basés sur une modification, dépendant du champ électrique, d'une propriété physique de la lumière passant au travers des éléments de transmission de lumière électro-optiques (2a, 2b), laquelle modification est causée par les éléments de transmission de lumière électro-optiques (2a, 2b),
mesure de signaux électriques $S_n$ en fonction des intensités de la lumière sortant de chaque élément de transmission de lumière électro-optique (2a, 2b),
détermination de toutes les tensions partielles $V_n$ selon

$$V_n = \frac{V_{h,n}}{\pi}\left(\left(\pm\arccos\left(\frac{2(S_n - b_n)}{G_n \cdot I_{n,0}} - 1\right) + K \cdot 2\pi\right) - 2\pi\Delta_n\right)$$

où $V_{h,n}$ = tension demi-onde d'un cristal (21) dans le n-ième élément de transmission de lumière électro-optique (2a, 2b), $b_n$ = décalage de signal, $G_n$ = gain cumulé de tous les composants dans une chaîne de mesure allant d'une photodiode à un amplificateur, $I_{n,0}$ = intensité de la lumière sortant avec un retard nul, K = compte des périodes d'une réponse cosinusoïdale et $\Delta_n$ = phase relative du signal par rapport à la tension (V, $V_n$) pour un canal n quelconque, et
utilisation du $\alpha_n$, plus particulièrement d'une estimation du $\alpha_n$ pour tous les canaux optiques, dans le but de lever l'ambiguïté quant au signe de l'arc-cosinus.

24. Procédé selon l'une quelconque des revendications 22-23, dans lequel l'étape de prise d'une décision binaire dans le but de lever l'ambiguïté quant au premier signal ($S_n$) du premier élément électro-optique (2a) auquel est appliquée la tension partielle ($V_1$) comprend l'utilisation du $\alpha_n$ dans le but de calculer, à partir des au moins deux hypothèses ($V_1^{h+}$, $V_1^{h-}$), les hypothèses de tension correspondantes ($V_2^{h+}$, $V_2^{h-}$) pour le deuxième élément électro-optique (2b) auquel est appliquée la tension partielle ($V_2$), et la sélection de la valeur attendue ($S_2^{h+}$, $S_2^{h-}$) du deuxième signal ($S_2$) la plus proche de la valeur mesurée du deuxième signal ($S_2$).

**25.** Procédé selon l'une quelconque des revendications 22-24, dans lequel des $\alpha_n$ fortement erronés sont détectés à partir d'une sélection d'hypothèse incorrecte, plus particulièrement à partir d'une discontinuité dans la tension mesurée (V), et les valeurs le plus courantes de $\alpha_n$ utilisées la plupart du temps sont déterminées comme étant les $\alpha_n$ corrects.

**26.** Procédé selon l'une quelconque des revendications 22-25, comprenant en outre l'étape de déduction récursive d'au moins un des paramètres internes ($\alpha_n$) par :

initialisation d'une boucle d'asservissement auxiliaire par l'estimation de $\alpha_n$ pour tous les canaux optiques, le paramètre interne ($\alpha_n$) décrivant une distribution de la tension (V) sur les éléments de transmission de lumière électro-optiques (2a, 2b),
prise d'une première série de mesures, et
sur la base de la $V_n$ ainsi obtenue, calcul d'un $\alpha_n$ plus exact à l'aide de l'équation $\alpha_n = V_n / V$ et des valeurs les plus courantes de $\alpha_n$.

**27.** Procédé selon la revendication 26, comprenant en outre les étapes suivantes :

utilisation du $\alpha_n$ plus exact comme nouvel estimé de $\alpha_n$, et
convergence du $\alpha_n$ et/ou suivi d'une dépendance temporelle $\alpha_n(t)$ du $\alpha_n$.

**28.** Procédé selon l'une quelconque des revendications précédentes, mettant en oeuvre, pour chaque n-ième élément de transmission de lumière électro-optique (2a, 2b) et ses signal de base ($S_n$) et/ou signal de référence ($S_n'$) correspondants, les étapes suivantes :

reconstitution d'une forme d'onde de la tension mesurée (V, $V_n$), plus particulièrement de la pleine tension (V) et/ou de la tension partielle ($V_n$) entre la première borne (1a) et la deuxième borne (1b),
calcul d'une moyenne temporelle sur un certain nombre de périodes de la forme d'onde reconstituée,
détermination, à partir de la moyenne temporelle, d'une tension de décalage continue apparente $V_{DC}$, et
calcul d'une phase relative $\Delta_n$ du signal de base ($S_n$) et/ou du signal de référence ($S_n'$) par rapport à la tension appliquée selon $\Delta_n = V_{DC} * \pi / V_{h,n}$, où $V_{h,n}$ = tension demi-onde du n-ième élément de transmission de lumière électro-optique (2a, 2b).

**29.** Procédé de mesure d'une tension (V, $V_n$) selon l'une quelconque des revendications précédentes, **caractérisé par** les étapes suivantes :

(i) utilisation du premier signal ($S_n$) comme un signal de base ($S_n$) indiquant le champ électrique sur le premier élément de transmission de lumière électro-optique (2a),
(ii) utilisation du deuxième signal ($S_n'$) comme un signal de référence ($S_n'$) pour la résolution de l'ambiguïté lors de la déduction de la tension (V, $V_n$),
(iii) détermination, à partir du premier signal ($S_n$), de deux hypothèses ($h^+$, $h^-$) correspondant à différentes valeurs de tension possibles ($V_n^{h+}$, $V_n^{h-}$) de la tension (V, $V_n$),
(iv) détermination du déphasage relatif réel $\Delta$ entre le signal de base $S_n$ et le signal de référence $S_n'$,
(v) détermination, à partir du signal de base $S_n$, du signal de référence $S_n'$ et du déphasage relatif réel $\Delta$, d'un signal en quatradure de synthèse $S_n'^{quad}$ présentant un déphasage relatif idéal de 90° par calcul de $S_n'^{quad}$ selon la formule

$$\texttt{S}_\texttt{n}\texttt{'}^{\texttt{quad}} \texttt{ = cos}^{\texttt{-1}}\texttt{(2*}\pi\texttt{*}\Delta\texttt{)} \texttt{ * S}_\texttt{n}\texttt{' + tan(2*}\pi\texttt{*}\Delta\texttt{)} \texttt{ * S}_\texttt{n}\texttt{,}$$

et
(vi) prise d'une décision binaire entre les hypothèses ($h^+$, $h^-$) sur la base du signe du signal en quadrature de synthèse $S_n'^{quad}$.

**30.** Dispositif de mesure de la tension (V) comprenant des moyens de mise en oeuvre des étapes du procédé selon l'une quelconque des revendications précédentes.

FIG. 1

FIG. 2a

FIG. 2b

FIG. 2c

FIG. 2d

**FIG. 3**

FIG. 4a

voltage measurement path     auxiliary control loops

initialization

$\Delta^{init}$ , $\Delta'^{init}$

acquire signals
S,S'

S,S'
reach
min&max
?

no

yes

normalize S,S'
to [-1;+1]

update $\Delta$,$\Delta'$

count zero crossings
in S

compute arccosine
of S
disambiguate sign using S'

$\Delta$,$\Delta'$

k

acos

compute applied
voltage V:
$V = V_h * k + acos$

V

Separate AC
and DC components

$V_{DC}$

Determine
$\Delta$,$\Delta'$

voltage measurement path       auxiliary control loop

$V_{AC}$

**FIG. 4b**

FIG. 5

FIG. 6a

case: $V_1 = V_2 = \alpha V$, $\alpha = 0.5$

**FIG. 6b**

case: $V_1/\alpha_1 = V_2/\alpha_2 = V$, $\alpha_1 > \alpha_2 > 0$

**FIG. 6c**

**FIG. 8**

FIG. 7

FIG. 9

Fig. 9

**FIG. 10a**

$$V_n = \beta_n \cdot V_{1n} + (1 - \beta_n) \cdot V_{2n}$$

**FIG. 10b**

$$V_n = \beta_n \cdot V_{1n} + (1 - \beta_n) \cdot V_{2n}$$

**FIG. 10c**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4904931 A
- US 5001419 A
- US 6252388 B

- US 5247244 A
- US 5715058 A
- EP 1179735 A

**Non-patent literature cited in the description**

- **L. DUVILLARET ; S. RIALLAND ; J.-L. COUTAZ.** Electro-optic sensors for electric field measurements. II. Choice of the crystal and complete optimization of their orientation. *J. Opt. Soc. Am.,* 2002, vol. B 19, 2704